# EUROPEAN PATENT APPLICATION

(11) **EP 4 459 684 A2**
(43) Date of publication of application: **06.11.2024**
(21) Application number: 24200566.8
(22) Date of filing: 12.05.2021
(51) Int. Cl.: H01L 33/02

(54) **FABRICATING A SILICON CARBIDE AND NITRIDE STRUCTURES ON A CARRIER SUBSTRATE**

(30) Priority: 14.05.2020 US 202016874588; 14.05.2020 US 202016874619
(62) Divisional of application: 21173648.3
(71) Applicant: The Boeing Company, Arlington, VA 22202 (US)
(72) Inventor: WHITELEY, Samuel J., Chicago, 60606-1596 (US); YAP, Daniel, Chicago, 60606-1596 (US); CHEN, Edward H., Chicago, 60606-1596 (US); KIM, Danny M., Chicago, 60606-1596 (US); LADD, Thaddeus D., Chicago, 60606-1596 (US)
(74) Representative: Smart, Jessica Ann

(57) **Abstract**

A method, apparatus, and system for forming a semiconductor structure. A first oxide layer (402, 912) located on a set of group III nitride layers (200, 908, 910, 1308, 1310, 1606, 1806, 2006, 2106, 2210, 2212, 2310, 2312) formed on a silicon carbide substrate (100, 1003) is bonded to a first oxide layer (504, 1002) located on a carrier substrate (500, 1000, 1314, 1602, 1802, 2002, 2102, 2202, 2302, 2402) to form an oxide layer (600, 1100, 1312, 1604, 1804, 2004, 2104, 2204, 2304) located between the carrier substrate (500, 1000, 1314, 1602, 1802, 2002, 2102, 2202, 2302, 2402) and the set of group III nitride layers (200, 908, 910, 1308, 1310, 1606, 1806, 2006, 2106, 2210, 2212, 2310, 2312). The silicon carbide substrate (100, 1003) has a doped layer (106, 904, 1302). The silicon carbide substrate (100, 1003) having the doped layer (106, 904, 1302) is etched using a photo-electrochemical etching process, wherein a doping level of the doped layer (106, 904, 1302) is such that the doped layer (106, 904, 1302) is removed and a silicon carbide layer in the silicon carbide substrate (100, 1003) remains unetched. The semiconductor structure is formed using the silicon carbide layer and the set of group III nitride layers (200, 908, 910, 1308, 1310, 1606, 1806, 2006, 2106, 2210, 2212, 2310, 2312).

## Description

### BACKGROUND INFORMATION

### 1. Field:

The present disclosure relates generally to semiconductors and, in particular, to a method for forming semiconductor structures and, in particular, to forming silicon carbide and nitride structures on a carrier substrate.

### Background:

Silicon carbide and group III nitrides, such as gallium nitride, are desirable semiconductors for signal processing and quantum applications. These materials have wide bandgaps greater than 3 eV and greater nonlinear optical coefficients as compared to other material such as silicon, silica, and silicon nitride materials currently used for low-loss photonics and on-chip nonlinear optics.

Silicon carbide (SiC) is a semiconductor material containing silicon and carbon. Silicon carbide can be used in devices for quantum information processing as well as for other purposes. For example, color centers in silicon carbide structures can be used to provide an optical readout indicative of their electron spin state. Each color center is a qubit in quantum computing. A state of the qubit can be a logic "0", a logic "1", or a superposition of the two states. For example, the color centers can be incorporated in photonic devices such as micro-cavities for waveguide elements.

Fabricating devices on silicon carbide structures can be challenging. For example, the devices formed using thin-films with silicon carbide and group III nitrides can be more difficult to fabricate than desired as compared to other materials such as silicon. A thin-film device includes one or more thin-film layers in which a thin-film layer can be from fractions of a nanometer to several micrometers in thickness.

The quality of thin-film devices using silicon carbide and group III nitrides formed on a wafer may not be as great as desired as compared to materials such as silicon. Therefore, it would be desirable to have a method and apparatus that take into account at least some of the issues discussed above, as well as other possible issues. For example, it would be desirable to have a method and apparatus that overcome a technical problem with forming silicon carbide and group III nitride structures having a desired quality.

### SUMMARY

An embodiment of the present disclosure provides a method for forming a semiconductor structure. A set of group III nitride layers is formed on a silicon carbide substrate. The silicon carbide substrate includes a doped layer. The doped layer has a doping level such that the doped layer is etched using a photo-electrochemical etching process and other portions of the silicon carbide substrate remain unetched. A first oxide layer is formed on the set of group III nitride layers. The set of group III nitride layers is located between the first oxide layer and the silicon carbide substrate. The first oxide layer is bonded to a second oxide layer on a carrier substrate to form an oxide layer located between the carrier substrate and the set of group III nitride layers. The silicon carbide substrate is ground. The grinding is stopped when a part of the doped layer in the silicon carbide substrate is reached exposed. The silicon carbide substrate is etched using the photo-electrochemical etching such that the doped layer is removed and a silicon carbide layer in the silicon carbide substrate remains when the part of the doped layer in the silicon carbide substrate is exposed. The semiconductor structure is formed using the silicon carbide layer and the set of group III nitride layers.

Another embodiment of the present disclosure provides a method for forming a semiconductor structure. A first oxide layer located on a set of group III nitride layers formed on a silicon carbide substrate is bonded to a second oxide layer located on a carrier substrate to form an oxide layer located between the carrier substrate and the set of group III nitride layers. The silicon carbide substrate has a doped layer. The silicon carbide substrate having the doped layer is etched using a photo-electrochemical etching process, wherein a doping level of the doped layer is such that the doped layer is removed and a silicon carbide layer in the silicon carbide substrate remains unetched. The semiconductor structure is formed using the silicon carbide layer and the set of group III nitride layers.

Yet another embodiment of the present disclosure provides a product management system comprising fabrication equipment and a control system. The control system controls the fabrication equipment to bond a first oxide layer located on a set of group III nitride layers formed on a silicon carbide substrate to a second oxide layer located on a carrier substrate to form an oxide layer located between the carrier substrate and the set of group III nitride layers. The silicon carbide substrate has a doped layer. The silicon carbide substrate having the doped layer is etched using a photo-electrochemical etching process. A doping level of the doped layer is such that the doped layer is removed and a silicon carbide layer in the silicon carbide substrate remains unetched. A semiconductor structure is formed using the silicon carbide layer and the set of group III nitride layers.

The features and functions can be achieved independently in various embodiments of the present disclosure or may be combined in yet other embodiments in which further details can be seen with reference to the following description and drawings.

### BRIEF DESCRIPTION OF THE DRAWINGS

The novel features believed characteristic of the illustrative embodiments are set forth in the appended claims. The illustrative embodiments, however, as well as a preferred mode of use, further objectives and features thereof, will best be understood by reference to the following detailed description of an illustrative embodiment of the present disclosure when read in conjunction with the accompanying drawings, wherein:
**Figure 1** is an illustration of a cross-sectional view of a silicon carbide substrate in accordance with an illustrative embodiment;
**Figure 2** is an illustration of a cross-sectional view of a set of group III nitride layers on a silicon carbide substrate in accordance with an illustrative embodiment;
**Figure 3** is an illustration of a cross-sectional view of structures formed using a set of group III nitride layers in accordance with an illustrative embodiment;
**Figure 4** is an illustration of a cross-sectional view of silicon dioxide deposited on a silicon carbide substrate covering structures formed on a bond face of the silicon carbide substrate in accordance with an illustrative embodiment;
**Figure 5** is an illustration of a cross-sectional view of a carrier substrate in accordance with an illustrative embodiment;
**Figure 6** is an illustration of a cross-sectional view of a silicon carbide substrate bonded to a carrier substrate in accordance with an illustrative embodiment;
**Figure 7** is an illustration of a cross-sectional view showing removal of a portion of a silicon carbide substrate in accordance with an illustrative embodiment;
**Figure 8** is an illustration of a cross-sectional view of a silicon carbide device layer in accordance with an illustrative embodiment;
**Figure 9** is an illustration of a cross-sectional view of a substrate in accordance with an illustrative embodiment;
**Figure 10** is an illustration of a cross-sectional view for bonding a workpiece to a carrier substrate in accordance with an illustrative embodiment;
**Figure 11** is an illustration of a cross-sectional view showing removal of a silicon carbide material from a silicon carbide substrate in accordance with an illustrative embodiment;
**Figure 12** is an illustration of a cross-sectional view of a silicon carbide material etched to reach a silicon carbide device layer in accordance with an illustrative embodiment;
**Figure 13** is an illustration of a cross-sectional view of a workpiece in accordance with an illustrative embodiment;
**Figure 14** is an illustration of a cross-sectional view of removal of a silicon carbide material in accordance with an illustrative embodiment;
**Figure 15** is an illustration of a cross-sectional view of a doped layer in reach of a silicon carbide device layer in accordance with an illustrative embodiment;
**Figure 16** is an illustration of a waveguide coupled optical resonator and filter in accordance with an illustrative example;
**Figure 17** is an illustration of a cross-sectional view of a waveguide coupled optical resonator and filter in accordance with an illustrative embodiment;
**Figure 18** is an illustration of an integrated optical waveguide containing a quantum memory in accordance with an illustrative example;
**Figure 19** is an illustration of a cross-sectional view of an integrated optical waveguide containing a waveguide coupled quantum memory in accordance with an illustrative embodiment;
**Figure 20** is a cross-sectional view of a waveguide in accordance with an illustrative embodiment;
**Figure 21** is another cross-sectional view of a waveguide in accordance with an illustrative embodiment;
**Figure 22** is yet another cross-sectional view of waveguide in accordance with an illustrative embodiment;
**Figure 23** is still another cross-sectional view of a waveguide in accordance with an illustrative embodiment;
**Figure 24** is another example of a silicon carbide substrate with a set of group III nitride layers in accordance with an illustrative embodiment;
**Figure 25** is an illustration of a flowchart of a process for forming a semiconductor structure in accordance with an illustrative embodiment
**Figure 26** is an illustration of a flowchart of a process for forming a semiconductor structure in accordance with an illustrative embodiment;
**Figure 27** is an illustration of a flowchart of a process for bonding components in accordance with an illustrative embodiment;
**Figure 28** is an illustration of a flowchart of a process for forming a semiconductor structure in accordance with an illustrative embodiment; and
**Figure 29** is an illustration of a block diagram of a product management system in accordance with an illustrative embodiment.

### DETAILED DESCRIPTION

The illustrative embodiments recognize and take into account one or more different considerations. For example, the illustrative embodiments recognize and take into account that currently used techniques can yield polycrystalline films of non-uniform silicon carbide across a wafer. Further, the illustrative embodiments recognize and take into account that when using current techniques to obtain a desired thickness for thin-film devices, material damage can occur in a silicon carbide film, thus leading to undesired optical absorption or scattering.

Further, the illustrative embodiments recognize and take into account that current techniques for fabricating silicon carbide (SiC) nano-photonics have primarily been restricted to 3C-SiC (cubic crystal structure) that is epitaxially grown on silicon (Si). The illustrative embodiments recognize and take into account that while 3C-SiC is simple to undercut on Si or silicon dioxide (SiO2) because of the chemical etch selectivity between SiC and Si/Si02, 3C-SiC devices can suffer from undesired optical losses that arise from dislocations, residual doping, high film strain, and interfacial defects at the Si-SiC growth interface.

The illustrative embodiments recognize and take into account that in order to mitigate interfacial defects, the 3C-SiC can be transferred to another substrate and a previous interface can be etched away. However, the illustrative embodiments recognize and take into account that the 3C-SiC contains a high inhomogeneous strain because of lattice mismatch with the Si substrate. In contrast to 3C-SiC films grown on Si substrates, the illustrative embodiments recognize and take into account that a single crystalline bulk and homoepitaxially grown 4H-SiC and 6H-SiC (hexagonal crystal structure) contain lower crystal strain and lower residual doping from growth. Therefore, the illustrative embodiments recognize and take into account that a 4H-SiC platform has great potential for photonics and other related fields. The illustrative embodiments recognize and take into account that the hexagonal SiC polytypes of silicon carbide, for example, 4H-, have also been pursued for photonics since the homoepitaxial growth of 4H-SiC on silicon carbide substrates yields crystalline material with very few lattice defects. The illustrative embodiments recognize and take into account that existing methods for isolating thin-films of 4H-SiC are limited given the material is grown on a bulk 4H-SiC substrate, such that currently used chemical etching of the base substrate is not possible.

The illustrative embodiments recognize and take into account that thin-films of hexagonal silicon carbide are suitable for photonics applications while allowing flexible pattern design and stacked layers. Thus, the illustrative embodiments provide a method, apparatus, and system for forming structures using silicon carbide and nitrides, such as group III nitrides, with a desired level of uniformity in film thickness while reducing damage or defects. In one illustrative example, a method forms a semiconductor structure. A first oxide layer located on a set of group III nitride layers formed on a silicon carbide substrate is bonded to a second oxide layer located on a carrier substrate to form an oxide layer located between a carrier substrate and the set of group III nitride layers. The silicon carbide substrate has a doped layer. The silicon carbide substrate having the doped layer is etched using a photo-electrochemical etching process, wherein a doping level of the doped layer is such that the doped layer is removed and a silicon carbide layer in the silicon carbide substrate remains unetched. The semiconductor structure can be formed using the silicon carbide layer and the set of group III nitride layers.

One or more illustrative examples enable fabricating semiconductor structures using silicon carbide as a platform to provide photonic functions. The semiconductor structures include at least one of an optical waveguide and an optical resonator. Functions of these structures include being a splitter, a directional coupler, a grating coupler, a micro-ring for a filter, a micro-disc for a filter, a non-linear optical frequency converter, a light emitter, and other types of functions. The illustrative examples enable fabricating these and other types of structures using wafer scale silicon carbide thin-films while preserving low optical loss.

As used herein, the phrase "at least one of," when used with a list of items, means different combinations of one or more of the listed items can be used, and only one of each item in the list may be needed. In other words, "at least one of" means any combination of items and number of items may be used from the list, but not all of the items in the list are required. The item can be a particular object, a thing, or a category.

For example, without limitation, "at least one of item A, item B, or item C" may include item A, item A and item B, or item B. This example also may include item A, item B, and item C or item B and item C. Of course, any combinations of these items can be present. In some illustrative examples, "at least one of" can be, for example, without limitation, two of item A; one of item B; and ten of item C; four of item B and seven of item C; or other suitable combinations.

Detailed embodiments of the claimed structures and methods are disclosed herein; however, it is to be understood that the disclosed embodiments are merely illustrative of the claimed structures and methods that may be embodied in various forms. In addition, each of the examples given in connection with the various embodiments is intended to be illustrative, and not restrictive.

Further, the figures are not necessarily to scale, as some features may be exaggerated to show details of particular components. Therefore, specific structural and functional details disclosed herein are not to be interpreted as limiting, but merely as a representative basis for teaching one skilled in the art to variously employ the methods and structures of the present disclosure.

For purposes of the description hereinafter, the terms "upper," "lower," "right," "left," "vertical," "horizontal," "top," "bottom," and derivatives thereof shall relate to the illustrative examples in the disclosure, as it is oriented in the drawing figures. The terms "positioned on" means that a first element, such as a first structure, is present on a second element, such as a second structure, wherein intervening elements, such as an interface structure, e.g. interface layer, may be present between the first element and the second element.

In this disclosure, when an element, such as a layer, a region, or a substrate, is referred to as being "on" or "over" another element, the element can be directly on the other element or intervening elements can also be present. In contrast, when an element is referred to as being "directly on," "directly over," or "on and in direct contact with" another element, no intervening elements are present, and the element is in contact with the other element.

The processes, steps, and structures described below do not form a complete process flow for manufacturing integrated circuits. The disclosure can be practiced in conjunction with integrated circuit fabrication techniques currently used in the art, and only so much of the commonly practiced process steps are included as necessary for an understanding of the different examples of the present disclosure. The figures represent cross-sections of a portion of an integrated circuit during fabrication and are not drawn to scale, but instead are drawn so as to illustrate different illustrative features of the disclosure.

In the illustrative examples, processes for manufacturing semiconductor structures can utilize two or more layers of silicon carbide having different doping types. The silicon carbide layers are epitaxially grown on a base silicon carbide substrate in the form of a wafer in the illustrative example. One or more of the silicon carbide layers can be doped by implantation. The silicon carbide layers with the base silicon carbide substrate can be referred to collectively as a silicon carbide substrate. Further, a layer of epitaxial group III nitride can be grown above the top-most silicon carbide layer in the silicon carbide substrate.

Further, one or more optional layers of epitaxial group III nitride layers can be present or grown on the first group III nitride layer. Examples of group III nitride layers that can be used include, for example, aluminum nitride (AlN), gallium nitride (GaN), aluminum gallium nitride (AlGaN), and other group III nitrides.

In the illustrative example, features can be at least one of patterned and etched into the group III nitride layers or deposited on the group III nitride layers. The top of this structure can be covered with a lower-refractive-index insulator such as an oxide layer formed from silicon dioxide. The oxide layer is a layer of silicon dioxide that can be deposited on a carrier substrate also in the form of a wafer. Both wafers are bonded together in the illustrative example.

In the illustrative example, an initial base silicon carbide substrate can be removed, at least partially, by grinding. In these depicted examples, the grinding can be at least one of mechanical grinding, polishing, or chemical-mechanical polishing (CMP). Mechanical grinding of the silicon carbide substrate can result in a silicon carbide layer that may have non-uniform thickness. The uniformity can become lower when the grinding is performed over distances measured in centimeters.

Afterwards, photo-electrochemical (PEC) etching can be performed to selectively remove the exposed, non-uniform silicon carbide layer until an etch-stop silicon carbide layer is reached. The photo-electrochemical etching can be performed from either a carbon-face or a silicon-face of the silicon carbide substrate in this example. A silicon carbide is a crystalline material and can have a silicon-face or a carbon-face, depending on the orientation. This silicon carbide layer functions as an etch-stop and can be at least one of semiinsulating or a different doping polarity as compared to the silicon carbide material being removed using photo-electrochemical (PEC) etching.

In the illustrative example, the resulting set of silicon carbide layers on the set of group III nitride layers can be made thinner than 1 um and, in some cases, can be thinner than 50 nm using the techniques in the illustrative examples.

In the illustrative example, additional planarization steps can be used. For example, mechanical polishing or chemical-mechanical polishing may be performed after at least one of material growth or photo-electrochemical (PEC) etching of the silicon carbide layer substrate. These processes can be performed to reduce roughness at various interfaces.

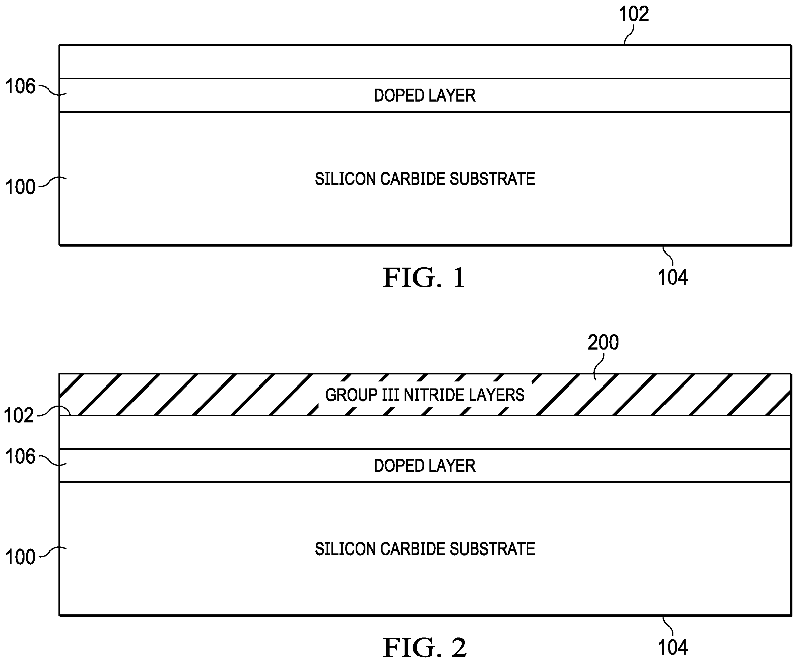

With reference now to **Figures 1-8****,** illustrations of cross-sections in a process to form a semiconductor structure are depicted in accordance with an illustrative embodiment. In **Figure 1****,** an illustration of a cross-sectional view of a silicon carbide substrate is depicted in accordance with an illustrative embodiment. As depicted, silicon carbide (SiC) substrate **100** can be in the form of a wafer. For example, silicon carbide substrate **100** can be a hexagonal silicon carbide wafer. The silicon carbide material can be, for example, a 4H or 6H crystal polytype in this example. As depicted, in this example, the silicon carbide material has a crystalline structure that is non-centrosymmetric and polar. As depicted, the wafer can, for example, have an area of 25 square centimeters or greater.

In this illustrative example, silicon carbide substrate **100** has bond face **102** and etch face **104.** More specifically, etch face **104** can be either a carbon-face or a silicon-face of silicon carbide substrate **100.** In this example, bond face **102** is the surface on which additional materials for a semiconductor structure are formed.

Additionally, silicon carbide substrate **100** has doped layer **106.** The doping to form doped layer **106** can be performed using any currently available doping techniques including at least one of diffusion or ion implantation. Doped layer **106** can be a layer from about 50 nanometers to tens of micrometers in thickness.

In this illustrative example, doped layer **106** can be a p-type layer or an n-type silicon carbide layer. The doping concentration is such that doped layer **106** can be etched using a photo-electrochemical etching process. In this illustrative example, the doping is such that doped layer **106** is etched by the photo-electrochemical etching process while other portions of silicon carbide substrate **100** under doped layer **106** and in direct contact with doped layer **106** remain unetched.

Turning next to **Figure 2****,** an illustration of a cross-sectional view of a set of group III nitride layers on a silicon carbide substrate is depicted in accordance with an illustrative embodiment. In the illustrative examples, the same reference numeral may be used in more than one figure. This reuse of a reference numeral in different figures represents the same element in the different figures.

As depicted, in this example, a set of group III nitride layers **200** are grown on bond face **102** of silicon carbide substrate **100.** The set of group III nitride layers **200** can be grown using currently available techniques for forming nitride layers.

As used herein, "a set of," when used with reference to items, means one or more items. For example, "a set of group III nitride layers **200"** is one or more of group III nitride layers **200.** As depicted, the set of group III nitride layers **200** can be thin-film layers in which each of these thin-film layers is from fractions of a nanometer to several micrometers in thickness. For example, a thin-film layer can be less than one micrometer.

In this illustrative example, the set of group III nitride layers **200** comprises at least one of gallium nitride (GaN), aluminum nitride (AlN), indium nitride (InN), indium aluminum gallium nitride (InAlGaN), or other suitable group III nitrides. In this example, the set of group III nitride layers **200** comprises an AlN layer that is at least 10 nanometers thick. Additional AlN, GaN, or AlₓGa₁₋ₓN layers can be optionally grown on top of this layer. These additional layers can be, for example, nanometers to several hundreds of microns thick. The number 'x' represents the Al:Ga ratio for the material's stoichiometry and 'x' can have a value between 0 and 1 in this example.

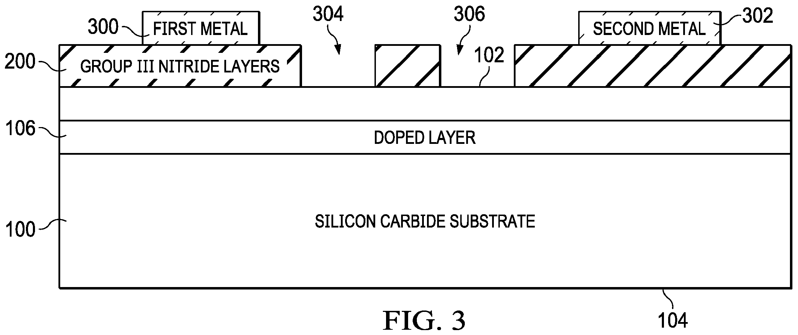

Turning next to **Figure 3****,** an illustration of a cross-sectional view of structures formed using a set of group III nitride layers is depicted in accordance with an illustrative embodiment. As depicted, first metal **300** and second metal **302** are formed on a set of group III nitride layers **200.** First metal **300** and second metal **302** can be formed using currently known techniques including industry-standard lithography and deposition techniques.

Additionally, the set of group III nitride layers **200** can be patterned and etched using currently known techniques such as defining a hard mask, etching the group III nitride material, and removing the hard mask. In this example, the patterning in etching forms first opening **304** and second opening **306** in the set of group III nitride layers **200** to expose bond face **102.**

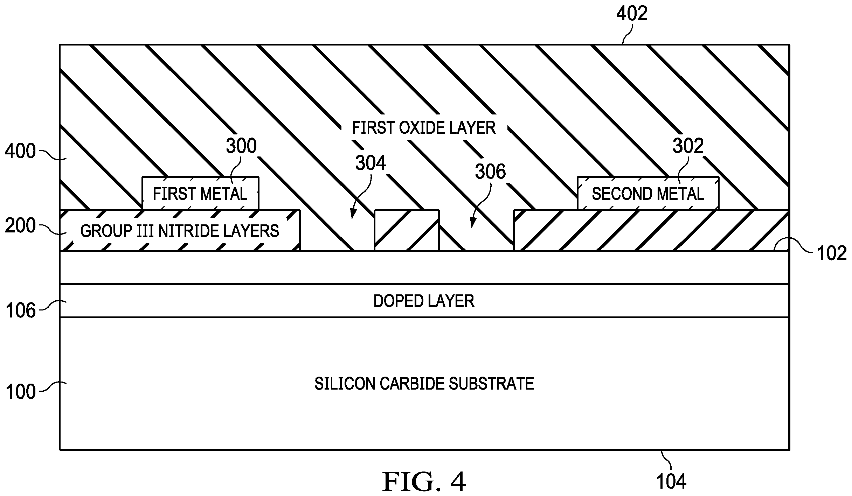

With reference now to **Figure 4****,** an illustration of a cross-sectional view of silicon dioxide deposited on a silicon carbide substrate covering structures formed on a bond face of the silicon carbide substrate is depicted in accordance with an illustrative embodiment. In this illustrative example, first oxide layer **400** is silicon dioxide that is deposited on first metal **300,** second metal **302,** a set of group III nitride layers **200,** and bond face **102** exposed in first opening **304** and second opening **306** of the set of group III nitride layers **200.** The deposition of silicon dioxide to form first oxide layer **400** can be performed using known techniques such as plasma enhanced chemical vapor deposition, sputtering, or another suitable, known technique for forming first oxide layer **400.**

As depicted, first oxide layer **400** has first surface **402.** In this example, first surface **402** can be processed using chemical-mechanical polishing (CMP) to improve planarity and reduce surface roughness. Further, first surface **402** of first oxide layer **400** can be treated or activated to be a hydrophilic surface.

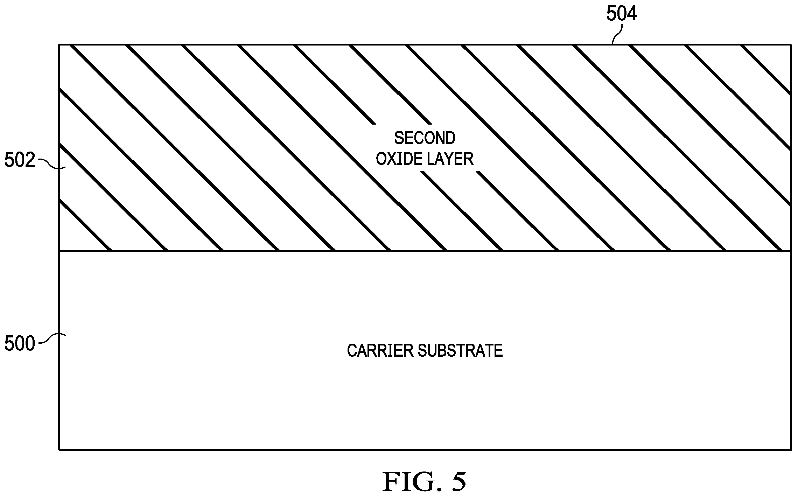

Turning now to **Figure 5****,** an illustration of a cross-sectional view of a carrier substrate is depicted in accordance with an illustrative embodiment. In this illustrative example, carrier substrate **500** can take a number of different forms. For example, carrier substrate **500** can be one of a silicon carbide substrate, a silicon substrate, an aluminum oxide substrate, a gallium oxide substrate, a silica substrate, an aluminum nitride substrate, a gallium nitride substrate, and other suitable substrates.

As depicted, carrier substrate **500** has second oxide layer **502** with second surface **504.** Second oxide layer **502** is comprised of silicon dioxide in this example. Second surface **504** can also be chemical-mechanically polished and treated or activated to be a hydrophilic surface.

In the illustrative example, silicon carbide substrate **100** in **Figure 4** and carrier substrate **500** in **Figure 5** can be bonded to each other. In this illustrative example, carrier substrate **500** is a substrate for the semiconductor structure. On the other hand, silicon carbide substrate **100** includes silicon carbide material that becomes a set of silicon carbide device layers used to form the semiconductor structure.

As depicted, first surface **402** of first oxide layer **400** on bond face **102** on silicon carbide substrate **100** in **Figure 4** can be placed into contact with second surface **504** of second oxide layer **502** in **Figure 5****.** The bonding by van der Waals forces occurs through contact between first surface **402** of first oxide layer **400** and second surface **504** of second oxide layer **502.** These substrates bonded to each other through the oxide layers can be annealed. The annealing can be performed at a temperature of at least 150 degrees C to strengthen the bond formed between the oxide layers of these two substrates.

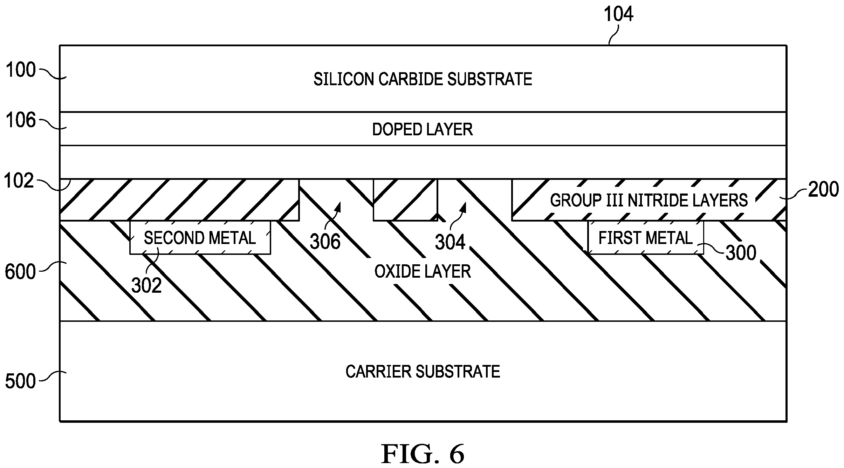

With reference now to **Figure 6****,** an illustration of a cross-sectional view of a silicon carbide substrate bonded to a carrier substrate is depicted in accordance with an illustrative embodiment. In this illustrative example, bonding of silicon carbide substrate **100** and carrier substrate **500** to each other forms oxide layer **600.** Carrier substrate **500** is the substrate for the semiconductor structure that is to be formed. Oxide layer **600** is a dielectric layer for the semiconductor structure. In other illustrative examples, other types of dielectrics may be used to form a dielectric layer in addition to or in place of oxide layer **600.**

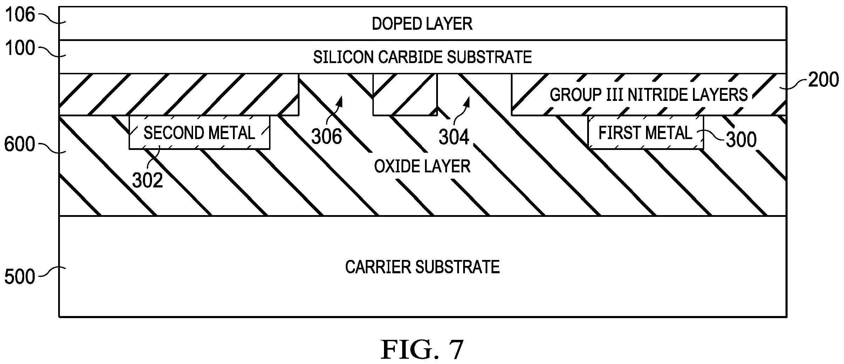

With reference now to **Figure 7****,** an illustration of a cross-sectional view showing removal of a portion of a silicon carbide substrate is depicted in accordance with an illustrative embodiment. As depicted, silicon carbide substrate **100** is thinned. This thinning can occur in stages. For example, silicon carbide substrate **100** can be ground starting from etch face **104** until doped layer **106** in silicon carbide substrate **100** is reached. In this depicted example, the grinding is a mechanical grinding that removes most of silicon carbide substrate **100** down to doped layer **106.** In this illustrative example, the grinding can stop at or extend into doped layer **106.**

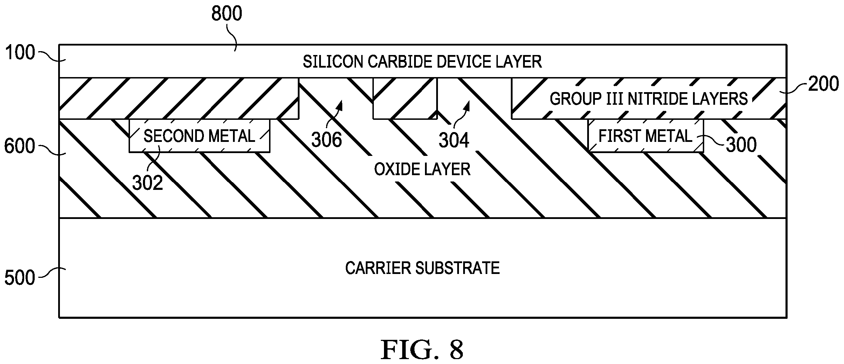

With reference now to **Figure 8****,** an illustration of a cross-sectional view of a silicon carbide device layer is depicted in accordance with an illustrative embodiment. When doped layer **106** is reached, additional thinning can be performed using a photo-electrochemical (PEC) etching process. As depicted, photo-electrochemical (PEC) etching is performed on the side of silicon carbide substrate **100** that has etch face **104,** which is not performed using currently available techniques.

This process can be used to remove doped layer **106.** The doping is selected such that other portions of silicon carbide substrate **100** under doped layer **106** are not removed by the photo-electrochemical etching process. Thus, doped layer **106** in silicon carbide substrate **100** functions as a sacrificial layer.

The portion of silicon carbide substrate **100** under doped layer **106** remains as silicon carbide device layer **800.** Silicon carbide device layer **800** is an example of a set of silicon carbide layers. In other illustrative examples, multiple silicon carbide layers can be present for use in forming the semiconductor structure. These additional semiconductor carbide layers may have different doping levels that distinguish the layers.

In this illustrative example, silicon carbide device layer **800** is a thin-film layer. In this illustrative example, silicon carbide device layer **800** has a thickness that is from about 10 nanometers to several micrometers. In some illustrative examples, silicon carbide device layer **800** is between about 50 nanometers and about 500 nanometers. Further, processing can be performed to fabricate one or more semiconductor structures using a workpiece comprising silicon carbide device layer **800,** a set of group III nitride layers **200,** and oxide layer **600** on carrier substrate **500.**

With the use of doped layer **106** and the photo-electrochemical etching process, silicon carbide device layer **800** can have a higher level of quality as compared to other currently used techniques. For example, silicon carbide device layer **800** can be a polycrystalline film having a desired uniformity across a wafer. Further, silicon carbide device layer **800** can have reduced inconsistencies or defects that result in reducing undesired optical absorption or scattering. Further, the process in the illustrative example can result in desired epitaxial growth of a desired quality in addition to a desired level of uniformity in film thickness. For example, a thickness variation of less than 50 nm can occur across a 100 mm wafer using the steps in the illustrative example.

The illustrations of the process of forming a semiconductor structure in **Figures 1-8** are an example of one manner in which an illustrative embodiment can be implemented. The example presented in these figures is not meant to limit the manner in which other illustrative examples can be implemented. For example, in another illustrative example, at least one of the set of group III nitride layers **200,** first metal **300,** or second metal **302** can be omitted.

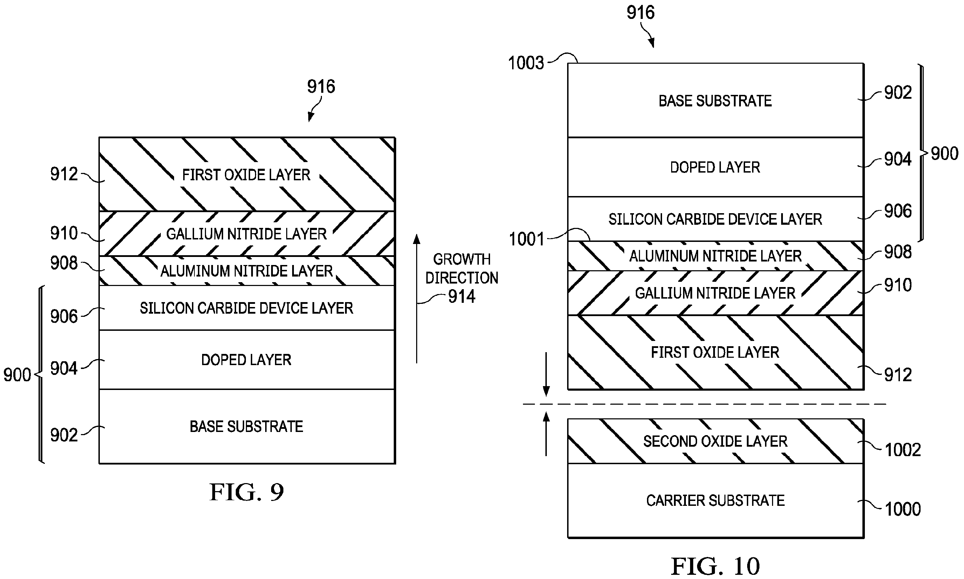

Turning next to **Figures 9-12****,** illustrations of cross-sections in a process to form a semiconductor structure are depicted in accordance with an illustrative embodiment. With reference first to **Figure 9****,** an illustration of a cross-sectional view of a substrate is depicted in accordance with an illustrative embodiment. As depicted, silicon carbide substrate **900** is comprised of base substrate **902,** doped layer **904,** and silicon carbide device layer **906.**

As depicted, base substrate **902** is a bulk 4H-SiC wafer that has a wafer normal miscut of 4 degrees or other small angle off-axis from the (0001) crystal direction. Doped layer **904** is a first layer grown as an epitaxial layer of 4H-SiC that is doped and is a sacrificial portion of silicon carbide substrate **900.** In this example, 4H-SiC is deposited with the desired specifications of thickness and doping to form silicon carbide device layer **906** in silicon carbide substrate **900.**

Further, a set of group III nitride layers, aluminum nitride (AlN) layer **908** and gallium nitride (GaN) layer **910,** are grown on silicon carbide device layer **906.** In this example, aluminum nitride layer **908** is an undoped AlN buffer layer that is epitaxially grown. Gallium nitride layer **910** can be formed to desired specifications using metal-organic chemical vapor deposition (MOCVD) or molecular beam epitaxy (MBE). The doping of gallium nitride layer **910** can be chosen at the growth stage depending on the application.

As depicted, first oxide layer **912** is deposited on gallium nitride layer **910.** In this example, silicon dioxide (SiO2) can be deposited to form first oxide layer **912** using a process such as plasma-enhanced chemical vapor deposition (PECVD), sputtering, or atomic layer deposition. In this illustrative example, the growth of various layers is in the direction of arrow **914.** These different layers form workpiece **916.**

With reference now to **Figure 10****,** an illustration of a cross-sectional view for bonding a workpiece to a carrier substrate is depicted in accordance with an illustrative embodiment. As depicted, workpiece **916** is flipped as compared to the view of workpiece **916** in **Figure 9****.** Workpiece **916** can then be bonded to carrier substrate **1000** which has second oxide layer **1002.** In this example, bond face **1001** and etch face **1003** are shown. As depicted, etch face **1003** can be a silicon-face or a carbon-face of silicon carbide substrate **900.**

In this illustrative example, carrier substrate **1000** can be silicon carbide, silicon, silica, aluminum oxide, or other suitable materials. As depicted, second oxide layer **1002** is formed using thermal oxidation, plasma enhanced chemical vapor deposition (PEVCD), sputtering, atomic level deposition, or other suitable processes.

In this illustrative example, the bonding can be performed by contact between the oxide layers. The contact is followed by annealing at a temperature of about 200 degrees C in this example.

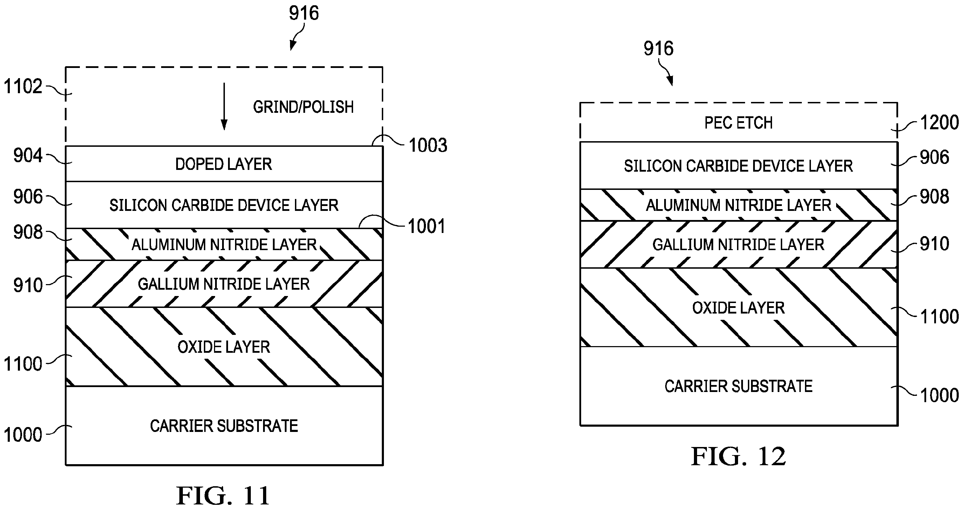

In **Figure 11****,** an illustration of a cross-sectional view of removal of a silicon carbide material from a silicon carbide substrate is depicted in accordance with an illustrative embodiment. In this figure, bonding of first oxide layer **912** and second oxide layer **1002** to each other forms oxide layer **1100.**

As depicted, silicon carbide substrate **900** is thinned by mechanical grinding and can be polished with chemical-mechanical polishing (CMP) as shown by section **1102.** Section **1102** indicates the silicon carbide material that has been removed. As shown, in this example, the removal extends into doped layer **904.**

In this example, mechanical polishing is used to remove a portion and not all of doped layer **904.** Mechanical grinding and polishing may be suitable in some cases such as over length scales from micrometers to millimeters. However, as larger length scales are present and thin-film thicknesses are desired across the entire wafer, and moreover the forces and stresses with this type of removal of material may introduce undesired inconsistencies such as lattice defects, dislocations, and crystal strain.

In this illustrative example, the mechanical grinding is stopped when the grinding extends into doped layer **904.** For example, the mechanical grinding can stop when doped layer **904** is still about a few micrometers thick.

Turning to **Figure 12****,** an illustration of a cross-sectional view of a silicon carbide material etched to reach a silicon carbide device layer is depicted in accordance with an illustrative embodiment. As depicted, in this cross-sectional view, a photo-electrochemical etching process is used to remove the remaining portion of doped layer **904** as shown in section **1200.** This etching exposes silicon carbide device layer **906** without removing material from silicon carbide device layer **906.** The dopant and doping level in doped layer **904** are selected such that doped layer **904** can be etched without removing material from silicon carbide device layer **906.**

With photo-electrochemical etching, dopant type selected etching can be performed in which doped layer **904** is removed to expose silicon carbide device layer **906.** In this illustrative example, silicon carbide device layer **906** can have desired properties such as a clean crystalline surface with a lower level of defect density as compared to using mechanical grinding.

In this illustrative example, the photo-electrochemical etching process can be performed while doped layer **904** is in contact with a solution such as a diluted potassium hydroxide or hydrofluoric acid and water.

Further, illumination of carrier substrate **1000** with the different layers can be performed using the illumination with a wavelength of light corresponding to a photon energy that is above the bandgap of silicon carbide. In this depicted example, a light source contains wavelengths shorter than 390 nm for 4H-SiC due to its bandgap of about 3.2 eV. A voltage bias can be applied between a contact on one of the sample's doped layers and a platinum electrode in the aqueous solution. The etch selectivity of p-type, n-type, and intrinsic material can be adjusted and optimized by controlling the direct current voltage bias magnitude and direction. Since the photo-electrochemical etching involves wet chemistry and is selective depending on the doping-type, the final result of thin-films of silicon carbide and group III nitrides have a desired level of uniformity and planarity across the wafer. This result is in contrast to currently available techniques such as smart-cut, which uses ion implantation to create an amorphous layer at a defined depth. The photo-electrochemical etching in the illustrative example avoids introducing new point defects or dopants into the silicon carbide and group III nitride thin-films.

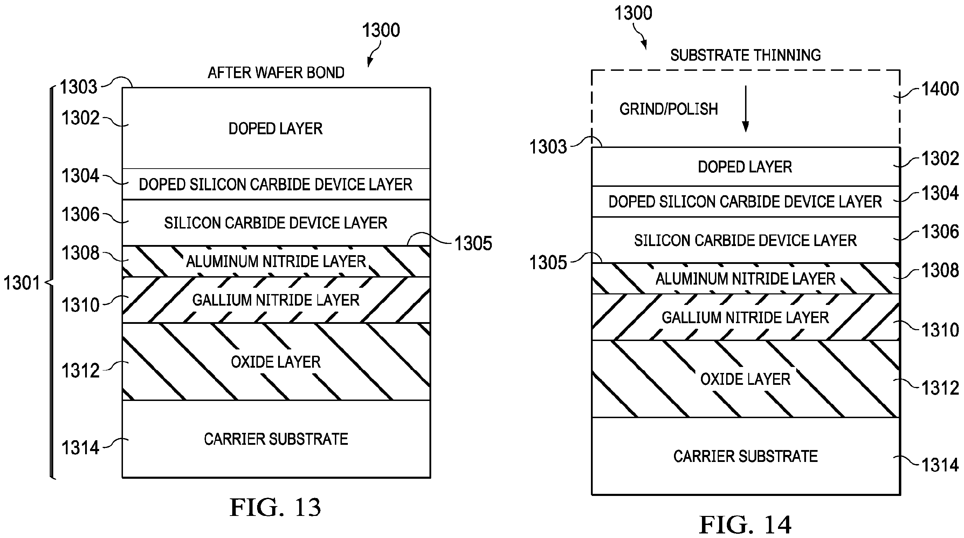

Next, **Figures 13-15** are cross-sectional views of a workpiece etched using photo-electrochemical etching in accordance with an illustrative embodiment. With reference to **Figure 13****,** an illustration of a cross-sectional view of a workpiece is depicted in accordance with an illustrative embodiment. As depicted, workpiece **1300** is a result of bonding a silicon carbide substrate to a carrier substrate in which a bond is formed between oxide layers on the two substrates.

In this illustrative example, workpiece **1300** comprises silicon substrate **1301,** which includes doped layer **1302,** doped silicon carbide device layer **1304,** silicon carbide device layer **1306,** aluminum nitride (AlN) layer **1308,** gallium nitride (GaN) layer **1310,** oxide layer **1312,** and carrier substrate **1314.** In this example, doped layer **1302** is a top layer and not located in other layers in silicon substrate **1301** as depicted in other prior examples. Workpiece **1300** has bond face **1305** and etch face **1303.** As depicted, etch face **1303** can be a silicon-face or a carbon-face.

As depicted, doped layer **1302** is an n-type layer. In other illustrative examples, doped layer **1302** can be a p-type layer. The doping differentials are selected to avoid etching of doped silicon carbide device layer **1304.** In other words, the doping level and doping type can be selected for doped silicon carbide device layer **1304** such that this layer functions as an etch-stop for the photo-electrochemical etching process.

In this depicted example, doped layer **1302** is a sacrificial layer that can be etched using a photo-electrochemical etching process. The doping level of doped layer **1302** is of a sufficiently different doping type, density, or both from doped silicon carbide device layer **1304,** which has a doping type and level to define an etch-stop. In this example, the etch selectivity can be maximized when doped layer **1302** is doped with a concentration that is greater than 1×10¹⁸ cm⁻³, and doped silicon carbide device layer **1304** has a doping concentration of at least 1×10¹⁸ cm⁻³ and an opposite dopant type to that of doped layer **1302.**

In this illustrative example, the type of dopant for doped layer **1302** is an n-type while the type of dopant for doped silicon carbide device layer **1304** is a p-type. If a different type of dopant is desired for doped silicon carbide device layer **1304,** such as a p-type dopant, then the type of dopant used in doped layer **1302** can be changed to an n-type dopant.

In another illustrative example, the sacrificial layer, doped layer **1302,** and the etch-stop layer, doped silicon carbide device layer **1304,** are doped to a concentration of about 1×10¹⁷ cm⁻³ concentration or greater. At doping levels of 1×10¹⁷ cm⁻³ and above, the etch rate of silicon carbide can depend on voltage bias present during the photo-electrochemical etching. The etch rate begins to vary more heavily with the doping concentration and is a factor that gives photo-electrochemical etching selectivity based on doping type.

Further, doped silicon carbide device layer **1304** can be, for example, about 100 nanometers or thicker. Silicon device layers below doped silicon carbide device layer **1304** can be any desired thickness formed from growth. For example, the thickness of these layers can be from about 50 nanometers to 200 microns thick with customizable doping concentrations. Nitride layers, such as a AlN layer and a GaN layer, can each have a thicknesses suitable for particular semiconductor devices.

In this illustrative example, a voltage bias can be applied through ohmic contacts to the surface of doped layer **1302.** Further, the surface of the silicon carbide layer is in contact with an aqueous potassium hydroxide solution and is exposed to light that is above bandgap energy. The light can have wavelengths shorter than 390 nanometers in this example.

Turning to **Figure 14****,** an illustration of a cross-sectional view of removal of a silicon carbide material is depicted in accordance with an illustrative embodiment. In this illustrative example, substrate thinning is performed by grinding and polishing to remove silicon carbide material from doped layer **1302** as seen by section **1400** that represents the removed silicon carbide material. This polishing can be mechanical polishing, chemical-mechanical polishing, or a combination of the two. As can be seen in this example, a portion of doped layer **1302** remains after the grinding and chemical mechanical polishing.

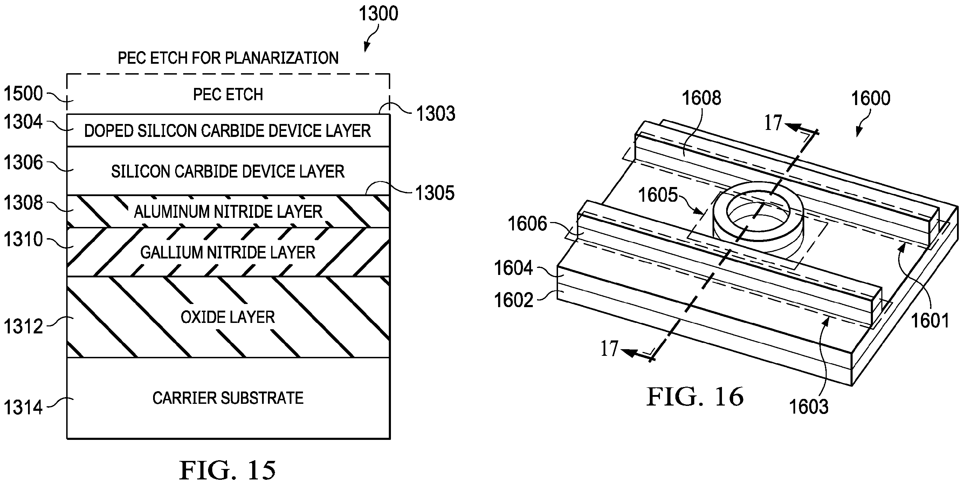

In **Figure 15****,** an illustration of a cross-sectional view of a doped layer in reach of a silicon carbide device layer is depicted in accordance with an illustrative embodiment. In this illustrative example, doped layer **1302** is etched using a photo-electrochemical etching process to reach doped silicon carbide device layer **1304,** which is an etch-stop layer in this example. Section **1500** shows the removed silicon carbide material.

Thus, the processes illustrated in **Figures 1-15** enable forming silicon carbide layers for use in devices with desired properties. For example, silicon carbide device layers can be formed on a scale of the size of a wafer to have a desired level of uniformity in the thickness of the layer. Additionally, the silicon carbide device layers can be formed with reduced levels of material damage such that undesired optical absorption or scattering can be avoided. With these processes, desired quality for the silicon carbide layers using devices can be obtained on larger sizes such as a wafer as compared to current techniques.

Turning next to **Figure 16****,** an illustration of a waveguide coupled optical resonator and filter is depicted in accordance with an illustrative example. As depicted, waveguide coupled optical resonator and filter **1600** is a semiconductor device formed on carrier substrate **1602** having oxide layer **1604,** aluminum nitride layer **1606,** and silicon carbide layer **1608.** Carrier substrate **1602** with oxide layer **1604,** aluminum nitride layer **1606,** and silicon carbide layer **1608** can be formed using the processes illustrated in **Figure 1-8****,** **Figures 9-12****,** and

### Figures 13-15.

In this illustrative example, aluminum nitride layer **1606** is in direct contact with silicon carbide layer **1608.** In other examples, one or more other layers can be located between aluminum nitride layer **1606** and silicon carbide layer **1608.**

In this example, waveguide coupled optical resonator and filter **1600** has three components. As depicted, waveguide coupled optical resonator and filter **1600** is comprised of linear waveguide **1601,** linear waveguide **1603,** and ring waveguide **1605.** In this example, waveguide coupled optical resonator and filter **1600** can filter selected wavelengths of light. For example, light traveling through linear waveguide **1601** can be passed into ring waveguide **1605.** Ring waveguide **1605** can pass a selected wavelength or selected wavelengths of light to linear waveguide **1603,** acting as a filter as to what light is passed from linear waveguide **1601** to linear waveguide **1603.**

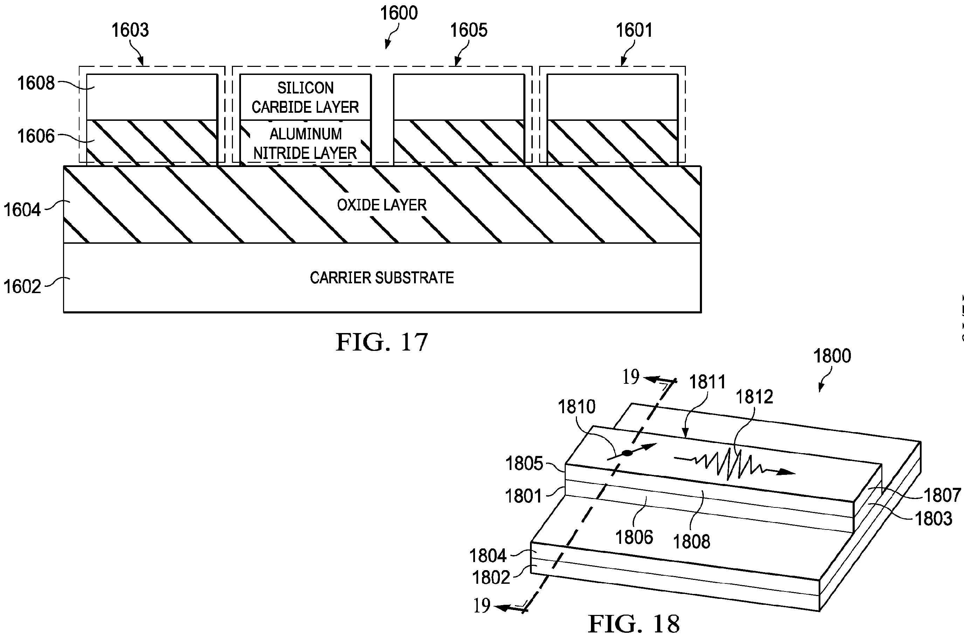

With reference to **Figure 17****,** an illustration of a cross-sectional view of a waveguide coupled optical resonator and filter is depicted in accordance with an illustrative embodiment. In this figure, a cross-sectional view of waveguide coupled optical resonator and filter **1600** is shown taken along line **17-17** in **Figure 16****.** In this example, oxide layers are bonded to form oxide layer **1604.** Thereafter, aluminum nitride layer **1606** and silicon carbide layer **1608** can be etched to form the structures that form linear waveguide **1601,** linear waveguide **1603,** and ring waveguide **1605.**

With reference to **Figure 18****,** an illustration of an integrated optical waveguide containing a quantum memory is depicted in accordance with an illustrative example. As depicted, quantum memory device **1800** is a semiconductor device formed on carrier substrate **1802** having oxide layer **1804,** aluminum nitride region **1806,** and silicon carbide region **1808.** In this example, carrier substrate **1802** with oxide layer **1804,** aluminum nitride region **1806,** and silicon carbide region **1808** can be formed using the processes illustrated in **Figure 1-8****,**

### Figures 9-12, and Figures 13-15.

As depicted, aluminum nitride region **1806** has side **1801** and side **1803.** Silicon carbide region **1808** has side **1805** and side **1807.**

In this example, quantum memory device **1800** includes quantum memory **1810** and integrated optical waveguide **1811.** Quantum memory **1810** is coupled to integrated optical waveguide **1811.** Quantum memory **1810** can be formed from a defect in the silicon carbide material in silicon carbide region **1808.** The defect can be, for example, a point defect selected from a divacancy, a silicon monovacancy, other vacancy complex, a transition metal ion, or a rare earth ion in silicon carbide region **1808.** Quantum memory **1810** can emit photon **1812** depending on the electron spin associated with that defect or color center, and the state of the photon can be entangled to the electron spin state. Photon **1812** emitted from quantum memory **1810** can travel into integrated optical waveguide **1811.**

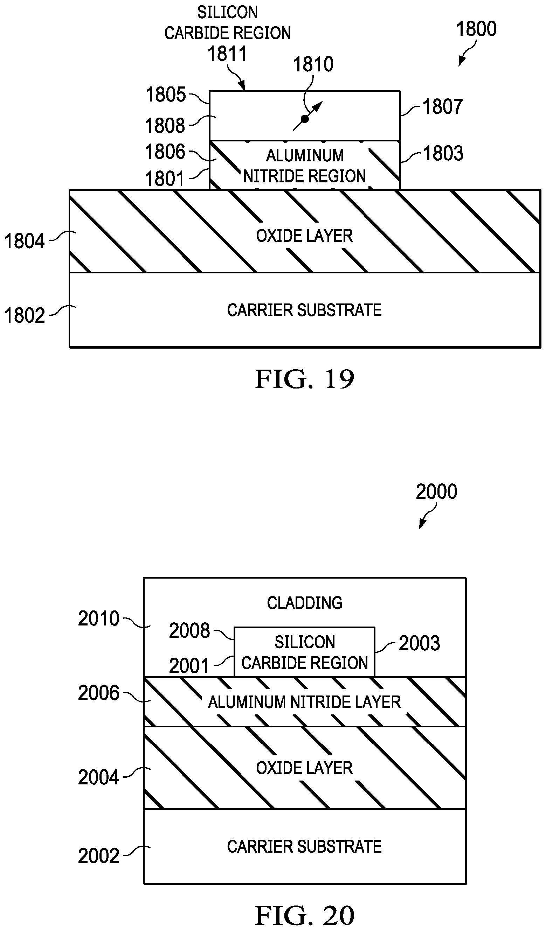

With reference to **Figure 19****,** an illustration of a cross-sectional view of an integrated optical waveguide containing a quantum memory is depicted in accordance with an illustrative embodiment. In this figure, a cross-sectional view of quantum memory device **1800** is shown taken along line **19-19** in **Figure 18****.**

Turning to **Figures 20-23****,** illustrations of waveguide structures fabricated are depicted in accordance with one or more illustrative embodiments. These depicted waveguide structures can be formed using the processes illustrated in **Figure 1-8****,** **Figures 9-12****,** and **Figures 13-15****.** These waveguides also could be used instead of the optical wave-guiding structures depicted in **Figures 16** and **18** and whose cross-sections are illustrated in **Figures 17** and **19****.**

With reference to **Figure 20****,** a cross-sectional view of a waveguide is depicted in accordance with an illustrative embodiment. As illustrated, waveguide **2000** is an example of a strip waveguide that can be formed in the illustrative examples.

In this depicted example, waveguide **2000** is formed on carrier substrate **2002.** Oxide layer **2004** is located on carrier substrate **2002.** Aluminum nitride layer **2006** is on oxide layer **2004,** and silicon carbide region **2008** is located on aluminum nitride layer **2006.** As shown in this figure, silicon carbide region **2008** has been patterned and etched to form waveguide **2000.**

As used herein, a region is a layer that does not extend without limit. A region has defined sides in this example. As depicted, silicon carbide region **2008** has side **2001** and side **2003.**

Cladding **2010** covers silicon carbide region **2008** and aluminum nitride layer **2006.** In this example, cladding **2010** is in direct contact with silicon carbide region **2008** and aluminum nitride layer **2006.** Cladding **2010** can be comprised of a material selected from at least one of an air, a vacuum, a resist, a polymer, a silicon nitride, a silicon dioxide, or some other material. In other words, cladding **2010** can be comprised of more than one type of material in some illustrative examples. In this example, cladding **2010** has a lower refractive index than the refractive index for silicon carbide region **2008.**

In this illustrative example, carrier substrate **2002** has a thickness that is from about 100 µm. Oxide layer **2004** has a thickness of about 3.0 µm in this example. Aluminum nitride layer **2006** has a thickness of about 200 nm, and silicon carbide region **2008** has a thickness of about 300 nm and a width of about 1.0 µm. Cladding **2010** has a thickness of about 500 nm to about 5.0 µm.

In this illustrative example, a silicon carbide layer can be etched to form silicon carbide region **2008** while aluminum nitride layer **2006** is not etched. This etching can be performed after bonding.

The cross-section of the structure depicted for waveguide **2000** in **Figure 20** can be used to form components for a semiconductor structure. For example, silicon carbide region **2008** can be duplicated to form four regions. The two outer regions can each be part of a linear waveguide and the two inner regions can be for a ring waveguide.

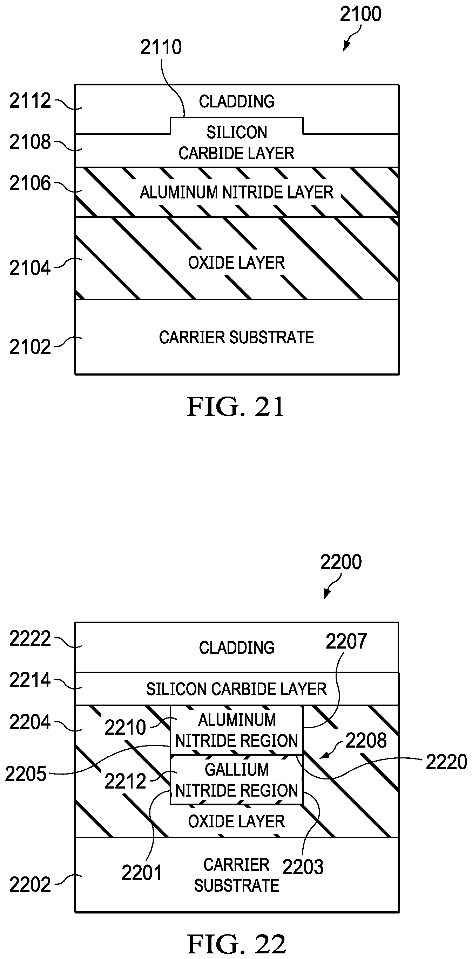

Turning next to **Figure 21****,** another cross-sectional view of a waveguide is depicted in accordance with an illustrative embodiment. As depicted, waveguide **2100** is an example of a rib waveguide that can be formed in the illustrative examples.

In this illustrative example, waveguide **2100** is formed on carrier substrate **2102.** Oxide layer **2104** is located on carrier substrate **2102.** Aluminum nitride layer **2106** is on oxide layer **2104,** and silicon carbide layer **2108** is located on aluminum nitride layer **2106.** Further, rib region **2110** is a region of silicon carbide that extends from silicon carbide layer **2108.** As shown in this figure, silicon carbide layer **2108** has been patterned and etched to form waveguide **2100** in the form of a rib waveguide having rib region **2110.**

Waveguide **2100** also has cladding **2112** that covers silicon carbide layer **2108** and rib region **2110.** In this example, cladding **2112** is in direct contact with these components. Cladding **2112** has a refractive index that is lower than silicon carbide layer **2108** and rib region **2110.**

In this illustrative example, carrier substrate **2102** has a thickness that is from about 100 µm. Oxide layer **2004** has a thickness of about 3.0 µm in this example.

Aluminum nitride layer **2106** has a thickness of about 200 nm. Silicon carbide layer **2108** has a thickness of about 100 nm. Rib region **2110** extending from silicon carbide layer **2008** has a thickness of about 200 nm and a width of about 1.0 µm. Cladding **2112** has a thickness of about 500 nm to about 5.0 µm.

In **Figure 22****,** yet another cross-sectional view of a waveguide is depicted in accordance with an illustrative embodiment. As illustrated, waveguide **2200** is an example of a buried ridge waveguide structure.

In this depicted example, waveguide **2200** is formed on carrier substrate **2202.** Oxide layer **2204** is located on carrier substrate **2202.** Gallium nitride region **2212** is located on oxide layer **2204** in cavity **2208** in oxide layer **2204.** Aluminum nitride region **2210** is located on gallium nitride region **2212** in cavity **2208** in oxide layer **2204.** Aluminum nitride region **2210** and gallium nitride region **2212** are an example of a set of group III nitride regions that may be buried in cavity **2208.**

Regions are layers that have defined sides and can be located within another material. In this example, gallium nitride region **2212** has side **2201** and side **2203** in cavity **2208** in oxide layer **2204.** Aluminum nitride region **2210** has side **2205** and side **2207** in cavity **2208** in oxide layer **2204.**

In this example, silicon carbide layer **2214** is located on oxide layer **2204** and aluminum nitride region **2210.** As shown in this figure, silicon carbide layer **2214,** aluminum nitride region **2210,** and gallium nitride region **2212** in cavity **2208** of oxide layer **2204** form waveguide **2200.** Aluminum nitride region **2210** and gallium nitride region **2212** form ridge **2220** buried in oxide layer **2204.** The refractive index of at least one of aluminum nitride region **2210** or gallium nitride region **2212** is higher than the refractive index of oxide layer **2204.**

As depicted, waveguide **2200** has cladding **2222** that covers silicon carbide layer **2214.** In this illustrative example, cladding **2222** is in direct contact with silicon carbide layer **2214.** Cladding **2222** has a refractive index that is lower than the refractive index of silicon carbide layer **2214.**

In this illustrative example, carrier substrate **2202** has a thickness about 100 µm. Oxide layer **2204** has a thickness of about 3.3 µm in this example. Aluminum nitride layer **2210** has a thickness of about 100 nm, and gallium nitride layer **2212** has a thickness of about 200 nm. These two layers in cavity **2208** have a width of about 1.0 µm. As depicted, silicon carbide layer **2214** has a thickness of about 200 nm. Cladding **2222** has a thickness of about 500 nm to about 5.0 µm.

In this example, an aluminum nitride layer and a gallium nitride region are etched to form aluminum nitride region **2210** and gallium nitride region **2212.** A first oxide layer is formed to bury aluminum nitride region **2210** and gallium nitride region **2212.** This first oxide layer is then bonded to a second oxide layer on carrier substrate **2202.** The first oxide layer and the second oxide layer can then be bonded to form oxide layer **2204.**

In this illustrative example, the semiconductor structure depicted in **Figure 22** can be fabricated using operations depicted in the illustrative examples. For example, group III nitride layers can be patterned and etched before depositing oxide and wafer bonding. The waveguide structures can be integrated with lateral (horizontal) diodes and doping for active electronics and depletion layers in silicon carbide layer **2214.** The doped regions could be fabricated either by masked implantation followed by annealing, or substrate (SiC and GaN) doping during growth followed by patterning and etching, or a combination thereof. Applying electric fields in these materials across p-n junctions or between metal contacts could be used to tune the resonance frequency of an optical resonator or optical emission frequency of embedded single photon emitters.

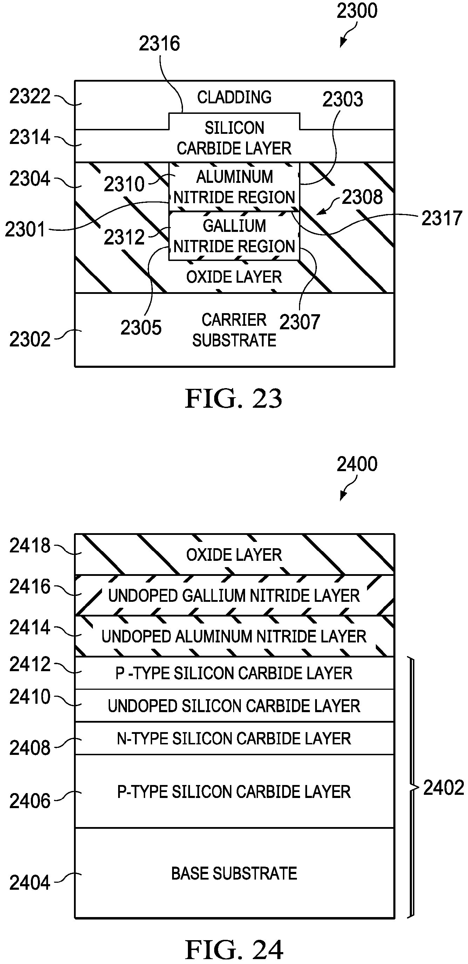

With reference now to **Figure 23****,** still another cross-sectional view of a waveguide is depicted in accordance with an illustrative embodiment. As illustrated, waveguide **2300** is another example of a buried optical waveguide structure.

In this depicted example, waveguide **2300** is formed on carrier substrate **2302.** Oxide layer **2304** is located on carrier substrate **2302.** Gallium nitride region **2312** is located on oxide layer **2304** in cavity **2308** in oxide layer **2304.** Aluminum nitride region **2310** is located on gallium nitride region **2312** in cavity **2308** in oxide layer **2304.** Aluminum nitride region **2310** has side **2301** and side **2303.** Gallium nitride region **2312** has side **2305** and side **2307.** As depicted, aluminum nitride region **2310** and gallium nitride region **2312** form ridge **2317** that is buried in cavity **2308** in oxide layer **2304.**

In this example, silicon carbide layer **2314** is located on oxide layer **2304** and aluminum nitride region **2310.** Further, rib region **2316** extends from silicon carbide layer **2314.** As shown in this figure, rib region **2316** is a portion of silicon carbide that extends from silicon carbide layer **2314** and can be referred to as a silicon carbide region. As depicted, silicon carbide layer **2314,** rib region **2316,** aluminum nitride region **2310,** and gallium nitride region **2312** in cavity **2308** of oxide layer **2304** form waveguide **2300.**

As depicted, waveguide **2300** has cladding **2322** that covers silicon carbide layer **2314** and rib region **2316.** As depicted, cladding **2222** is in direct contact with silicon carbide layer **2214** and rib region **2316.** Cladding **2222** has a refractive index that is lower than silicon carbide layer **2214** and rib region **2316.**

In this illustrative example, carrier substrate **2302** has a thickness that is from about 100 µm. Oxide layer **2304** has a thickness of about 3.3 µm in this example. Aluminum nitride region **2310** has a thickness of about 100 nm, and gallium nitride region **2312** has a thickness of about 200 nm. These two regions in cavity **2308** have a width of about 1.0 µm. As depicted, silicon carbide layer **2214** has a thickness of about 100 nm. Rib region **2316** has a width of about 1.0 µm and a thickness of about 200 nm. Cladding **2322** has a thickness of about 500 nm to about 5.0 µm.

The illustrations of waveguide structures in **Figures 20-23** are provided as an example of one type of semiconductor structure that can be fabricated in accordance with one or more illustrative examples. These illustrations are not meant to limit the manner in which other illustrative examples can be implemented.

For example, the thicknesses illustrated for these layers and regions are examples of thicknesses that can be used for thin-film implementations. These thicknesses are not meant to limit the thicknesses that can be used in other illustrative examples.

Further, the number and types of group III nitride layers and regions can vary from those illustrated in **Figures 20-23****.** For example, an indium nitride (InN) layer and an indium aluminum gallium nitride (InAlGaN)layer can be used in addition to or in place of the aluminum nitride (AlN) and gallium nitride (GaN) layers depicted.

As another example, other types of semiconductor structures can be fabricated in addition to or in place of waveguide structures. For example, a semiconductor structure can include at least one of a superconducting single photon detector, an optical emitter, a quantum memory using a point defect within the silicon carbide device layer, or other suitable types of components in the semiconductor structure.

Additional examples of semiconductor structures with one or more silicon carbide device layers and one or more group III nitride layers that can be fabricated using operations in one or more illustrative examples comprise micro-electromechanical systems and photonic components including waveguide-coupled four-port and two-port ring resonators or filters. In still other illustrative examples, superconducting materials can be deposited in a manner that allows for the operation of superconducting nanowire single photon detectors and logical components at cryogenic temperatures alongside the photonic, electrical, and mechanical components.

As another example, with slot waveguides, the optical mode can be selected for a lower refractive index cladding or vacuum outside the substrate by etching two ridges closely spaced together. The spacing can be, for example, less than a few hundred nanometers. As another example, suspended waveguides can be fabricated from similar material stacks as those depicted in these figures by lithographically patterning and then chemically etching away oxide (SiO2) in selective areas, which would yield an optical spatial mode that extends more into air or vacuum instead of into the oxide layer.

With reference next to **Figure 24****,** another example of a silicon carbide substrate with a set of group III nitride layers is depicted in accordance with an illustrative embodiment. In this illustrative example, workpiece **2400** is an example of layers that can be formed and bonded to a carrier substrate such as carrier substrate **500** in **Figure 5****.**

In this example, silicon carbide substrate **2402** in workpiece **2400** comprises base substrate **2404,** p-type silicon carbide layer **2406,** n-type silicon carbide layer **2408,** undoped silicon carbide layer **2410,** and p-type silicon carbide layer **2412.** As depicted, p-type silicon carbide layer **2406** is a sacrificial layer for performing photo-electrochemical etching. The other silicon carbide layers are examples of silicon carbide device layers that can be used in forming semiconductor structures. In this example, n-type silicon carbide layer **2408** can function as an etch-stop in addition to being a device layer.

In this illustrative example, base substrate **2404** has a thickness of about 350 µm. As depicted, the sacrificial layer, p-type silicon carbide layer **2406,** has a thickness of about 5 µm. In this example, n-type silicon carbide layer **2408** has a thickness of about 0.1 µm; undoped silicon carbide layer **2410** has a thickness of about 0.2 µm; and p-type silicon carbide layer **2412** has a thickness of about 0.1 µm.

As depicted, group III nitride layers are grown on p-type silicon carbide layer **2412** in silicon carbide substrate **2402.** These group III nitride layers comprise undoped aluminum nitride layer **2414** and undoped gallium nitride layer **2416.** In this illustrative example, undoped aluminum nitride layer **2414** has a thickness of about 0.1 µm, and undoped gallium nitride layer **2416** has a thickness of about 0.4 µm.

In this depicted example, oxide layer **2418** is deposited on undoped gallium nitride layer **2416.** Oxide layer **2418** has a thickness of about 0.2 µm in this example.

With workpiece **2400,** thin-films of silicon carbide and group III nitrides can be stacked on top of a material with a lower index of refraction (n) such as SiO2 such as n being about 1.4 for SiO2, 2.1/2.3 for monocrystalline AlN/GaN, and 2.6 for 4H-SiC, respectively. As a result, optical modes in a photonic device can stay within at least one of the silicon carbide or group III nitrides layers without radiating or losing optical energy into the bulk substrate material below.

Further, the silicon carbide layers in the group III nitride layers depicted in workpiece **2400** can be used to create a p-i-n junction within the silicon carbide material. In this example, the use of undoped aluminum nitride layer **2414** can be beneficial and can result in fewer un-passivated interface states (especially at cryogenic temperatures) compared to an exposed surface of SiC or a direct interface between silicon carbide and an oxide. The use of one or more additional group III nitride layers are optional in the illustrative examples.

The illustration of workpiece **2400** is provided as an example of one manner in which a silicon carbide substrate with a set of group III nitride layers can be implemented. This illustration is not meant to limit the manner in which other illustrative examples can be implemented.

For example, other illustrative examples can have other numbers of layers with the silicon carbide substrate. In some illustrative examples, the layer adjacent to the sacrificial layer can be an undoped layer rather than a layer with an opposite type of doping from the sacrificial layer. In yet another illustrative example, three, five, or some other number of group III nitride layers can be employed. Further, the example thicknesses for the layers are provided as examples of thicknesses that can be used with thin-film layers. Other thicknesses can be used in other examples.

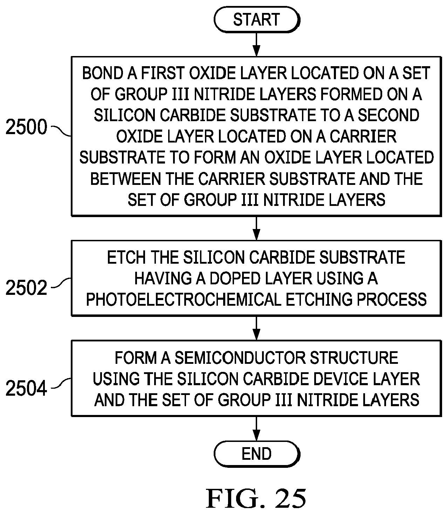

Turning next to **Figure 25****,** an illustration of a flowchart of a process for forming a semiconductor structure is depicted in accordance with an illustrative embodiment. The process begins by bonding a first oxide layer located on a set of group III nitride layers formed on a silicon carbide substrate to a second oxide layer located on a carrier substrate to form an oxide layer located between the carrier substrate and the set of group III nitride layers (operation **2500**). The silicon carbide substrate has a doped layer.

The process etches the silicon carbide substrate having the doped layer using a photo-electrochemical etching process (operation **2502**). A doping level of the doped layer is such that the doped layer is removed and a silicon carbide device layer in the silicon carbide substrate remains unetched. In operation **2502,** the doped layer is a sacrificial layer enabling forming the silicon carbide device layer on a substrate such as a wafer with at least one of a desired uniformity in a thickness of the silicon carbide device layer or a desired level of optical performance. In operation **2502,** the photo-electrochemical etching is performed on an etch face which can be the silicon-face or, for this example, is a carbon-face of the silicon carbide material. The photo-electrochemical etching also can be performed on an etch face that is a silicon-face of the silicon carbide material.

The process forms a semiconductor structure using the silicon carbide device layer and the set of group III nitride layers (operation **2504**). The process terminates thereafter. In this example, the silicon carbide device layer and the set of group III nitride layers can be thin-film layers. The semiconductor structure is selected from at least one of an optical waveguide, a slot waveguide, a ridge waveguide, a rib waveguide, a buried optical waveguide, a suspended waveguide, an optical resonator, a photon emitting quantum memory using a point defect within the silicon carbide device layer, or some other suitable structure. A semiconductor structure can include multiple components. For example, the semiconductor structure can include multiple waveguides of the same type or of different types. As another example, the semiconductor structure can include one or more waveguides and a quantum memory. These and other components can be selected to provide a desired function or functions for the semiconductor structure.

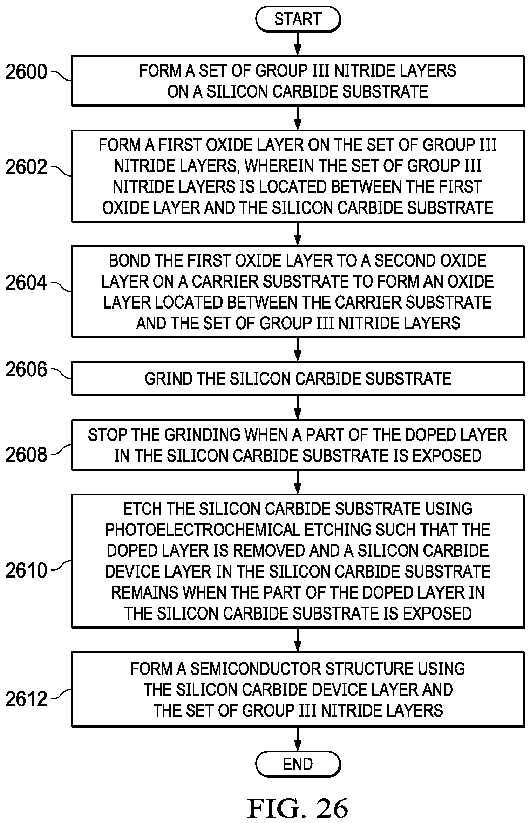

With reference next to **Figure 26****,** an illustration of a flowchart of a process for forming a semiconductor structure is depicted in accordance with an illustrative embodiment. The process begins by forming a set of group III nitride layers on a silicon carbide substrate (operation **2600**). The silicon carbide substrate includes a doped layer. The doped layer has a doping level such that the doped layer is etched using a photo-electrochemical etching process while other portions of the silicon carbide substrate remain unetched. In other illustrative examples, forming of the set of group III nitride layers can include etching the set of group III nitride layers to form structures.

The process forms a first oxide layer on the set of group III nitride layers, wherein the set of group III nitride layers is located between the first oxide layer and the silicon carbide substrate (operation **2602**). The process bonds the first oxide layer to a second oxide layer on a carrier substrate to form an oxide layer located between the carrier substrate and the set of group III nitride layers (operation **2604**)**.**

The process grinds the silicon carbide substrate (operation **2606**). The process stops the grinding when a part of the doped layer in the silicon carbide substrate is exposed (operation **2608**). In operation **2608,** the part of the doped exposed layer can be the top portion of the doped layer or some portion within the doped layer.

The process etches the silicon carbide substrate using photo-electrochemical etching such that the doped layer is removed and a silicon carbide device layer in the silicon carbide substrate remains when the part of the doped layer in the silicon carbide substrate is exposed (operation **2610**).

The process forms a semiconductor structure using the silicon carbide device layer and the set of group III nitride layers (operation **2612**). The process terminates thereafter.

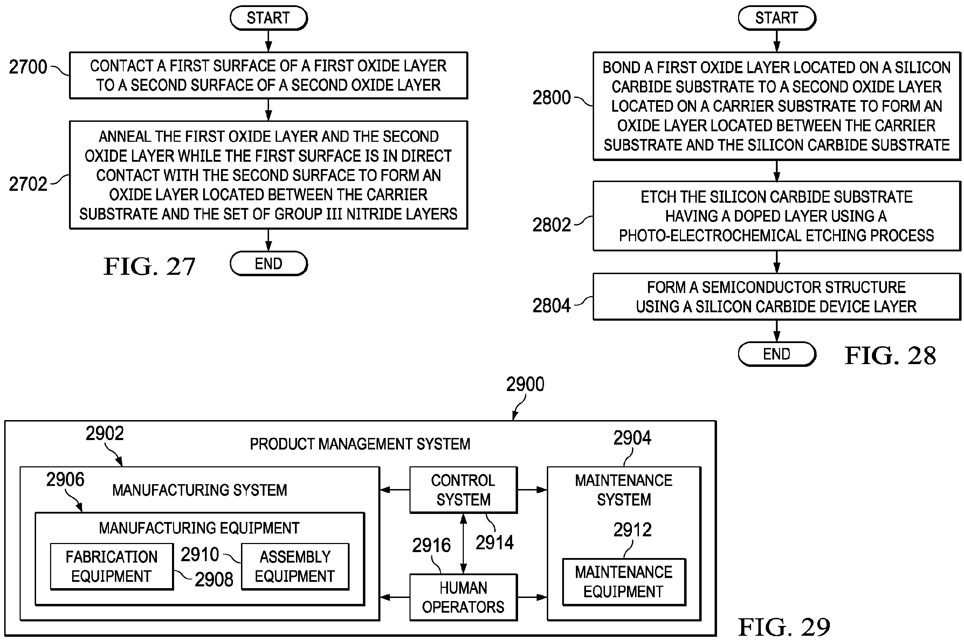

Turning next to **Figure 27****,** an illustration of bonding components is depicted in accordance with an illustrative embodiment. The flowchart in **Figure 27** is an example of one implementation for performing operation **2500** in **Figure 25** and operation **2604** in **Figure 26****.**

The process begins by contacting a first surface of a first oxide layer to a second surface of a second oxide layer (operation **2700**). In operation **2700,** intermolecular interactions occur between the first oxide layer and the second oxide layer. These intermolecular interactions include, for example, at least one of Van der Waals forces, hydrogen bonds, or strong covalent bonds.

The process anneals the first oxide layer and the second oxide layer while the first surface is in direct contact with the second surface to form an oxide layer located between a carrier substrate and a set of group III nitride layers (operation **2702**). In this example, annealing in operation **2702** is optional. The process terminates thereafter.

Turning to **Figure 28****,** an illustration of a flowchart of a process for forming a semiconductor structure is depicted in accordance with an illustrative embodiment. The process begins by bonding a first oxide layer located on a silicon carbide substrate to a second oxide layer located on a carrier substrate to form an oxide layer located between the carrier substrate and the silicon carbide substrate (operation **2800**).

In operation **2800,** the silicon carbide substrate has a doped layer. Further, the first oxide layer is in direct contact with the silicon carbide substrate in one illustrative example. In another illustrative example, a set of intervening layers, such as a set of group III nitride layers, is located between the first silicon layer and the silicon carbide substrate.

The process etches the silicon carbide substrate having a doped layer using a photo-electrochemical etching process (operation **2802**). In operation **2802,** a doping level of the doped layer is such that the doped layer is removed and a silicon carbide device layer in the silicon carbide substrate remains unetched.

The process forms a semiconductor structure using a silicon carbide device layer (operation **2804**). In operation **2804,** other materials can also be used to form the semiconductor structure. For example, the set of group III layers or regions can be formed in this operation. Also, at least one of a cladding, a metal layer, or a metal region can also be formed in operation **2804** to form the semiconductor structure.

The flowcharts and block diagrams in the different depicted embodiments illustrate the architecture, functionality, and operation of some possible implementations of apparatuses and methods in an illustrative embodiment. In this regard, each block in the flowcharts or block diagrams can represent at least one of a module, a segment, a function, or a portion of an operation or step. For example, one or more of the blocks can be implemented as instructions in program code, hardware, or a combination of the program code and hardware to control fabrication equipment for manufacturing semiconductor structures. When implemented in hardware, the hardware can, for example, take the form of integrated circuits that are manufactured or configured to perform one or more operations in the flowcharts or block diagrams. When implemented as a combination of program code and hardware, the implementation may take the form of firmware. Each block in the flowcharts or the block diagrams can be implemented using special purpose hardware systems that perform the different operations or combinations of special purpose hardware and program code run by the special purpose hardware to operate fabrication equipment to manufacture semiconductor structures.

In some alternative implementations of an illustrative embodiment, the function or functions noted in the blocks may occur out of the order noted in the figures. For example, in some cases, two blocks shown in succession may be performed substantially concurrently, or the blocks may sometimes be performed in the reverse order, depending upon the functionality involved. Also, other blocks may be added in addition to the illustrated blocks in a flowchart or block diagram.

For example, the bonding performed in operation 2604 is shown as being performed prior to etching the silicon carbide substrate in operation **2610.** In other illustrative examples, the bonding in operation **2604** can be performed after etching occurs in operation **2610.** As another example, other dielectrics having desired properties, such as a desired dielectric constant, can be used in place of or in addition to the silicon dioxide shown and described for the figures.

Turning now to **Figure 29****,** an illustration of a block diagram of a product management system is depicted in accordance with an illustrative embodiment. Product management system **2900** is a physical hardware system. In this illustrative example, product management system **2900** includes at least one of manufacturing system **2902** or maintenance system **2904.**

Manufacturing system **2902** is configured to manufacture products. As depicted, manufacturing system **2902** includes manufacturing equipment **2906.** Manufacturing equipment **2906** includes at least one of fabrication equipment **2908** or assembly equipment **2910.**

Fabrication equipment **2908** is equipment that used to fabricate components for parts used to form a product. Fabrication equipment **2908** can be used to fabricate at least one of metal parts, composite parts, semiconductors, circuits, fasteners, ribs, skin panels, spars, antennas, or other suitable types of parts.

For example, fabrication equipment **2908** can include machines and tools. These machines and tools can be at least one of a drill, a hydraulic press, a furnace, a mold, a composite tape laying machine, a vacuum system, a lathe, or other suitable types of equipment.

With respect to fabricating semiconductor components, fabrication equipment **2908** can comprise at least one of an epitaxial reactor, an oxidation system, a diffusion system, an etching machine, a cleaning machine, a bonding machine, a dicing machine, a wafer saw, an ion implantation machine, a physical vapor deposition system, a chemical vapor deposition system, a photolithography system, an electron-beam lithography system, a plasma etcher, a die attachment machine, a wire bonder, a die overcoat system, molding equipment, a hermetic sealer, an electrical tester, a burn-in oven, a retention bake oven, a UV erase machine, or other suitable types of equipment that can be used to manufacture semiconductor structures.

Assembly equipment **2910** is equipment used to assemble parts to form a product such as a chip, an integrated circuit, a computer, an aircraft, or some other product. Assembly equipment **2910** also can include machines and tools. These machines and tools may be at least one of a robotic arm, a crawler, a fastener installation system, a rail-based drilling system, or a robot.

In this illustrative example, maintenance system **2904** includes maintenance equipment **2912.** Maintenance equipment **2912** can include any equipment needed to perform maintenance on a product. Maintenance equipment **2912** may include tools for performing different operations on parts on a product. These operations can include at least one of disassembling parts, refurbishing parts, inspecting parts, reworking parts, manufacturing replacement parts, or other operations for performing maintenance on the product. These operations can be for routine maintenance, inspections, upgrades, refurbishment, or other types of maintenance operations.

In the illustrative example, maintenance equipment **2912** may include ultrasonic inspection devices, x-ray imaging systems, vision systems, drills, crawlers, and other suitable devices. In some cases, maintenance equipment **2912** can include fabrication equipment **2908,** assembly equipment **2910,** or both to produce and assemble parts that needed for maintenance.

Product management system **2900** also includes control system **2914.** Control system **2914** is a hardware system and may also include software or other types of components. Control system **2914** is configured to control the operation of at least one of manufacturing system **2902** or maintenance system **2904.** In particular, control system **2914** can control the operation of at least one of fabrication equipment **2908,** assembly equipment **2910,** or maintenance equipment **2912.**

The hardware in control system **2914** can be implemented using hardware that may include computers, circuits, networks, and other types of equipment. The control may take the form of direct control of manufacturing equipment **2906.** For example, robots, computer-controlled machines, and other equipment can be controlled by control system **2914.** In other illustrative examples, control system **2914** can manage operations performed by human operators **2916** in manufacturing or performing maintenance on a product. For example, control system **2914** can assign tasks, provide instructions, display models, or perform other operations to manage operations performed by human operators **2916.** In these illustrative examples, the different steps described and illustrated for fabricating semiconductor structures using silicon carbide and group III nitride layers can be implemented using control system **2914.**

In the different illustrative examples, human operators **2916** can operate or interact with at least one of manufacturing equipment **2906,** maintenance equipment **2912,** or control system **2914.** This interaction can occur to manufacture semiconductor structures and other components for products such as semiconductor devices or components for use in products such as aircraft, spacecraft, communications systems, micro-electromechanical systems, photonic devices, or superconducting single photon detectors.

Thus, the illustrative examples provide a method, apparatus, and system for manufacturing semiconductor structures. In one illustrative example, a method forms a semiconductor structure. A first oxide layer located on a set of group III nitride layers formed on a silicon carbide substrate is bonded to a second oxide layer located on a carrier substrate to form an oxide layer located between the carrier substrate and the set of group III nitride layers. The silicon carbide substrate has a doped layer. The silicon carbide substrate having the doped layer is etched using a photo-electrochemical etching process, wherein a doping level of the doped layer is such that the doped layer is removed and a silicon carbide layer in the silicon carbide substrate remains unetched. The semiconductor structure is formed using the silicon carbide layer and the set of group III nitride layers.

Further, the processes in the illustrative examples are suitable for processing large-area wafers such as those that with an area of 10 cm2 or greater. The illustrative examples are compatible with currently used processes for these types of wafers to produce low-loss, high-thickness-uniformity silicon carbide and group III nitride-based crystalline structures on low-refractive-index insulators. This enables the production of active and passive integrated photonics and electronics in silicon carbide and group III nitrides.

For example, the illustrative example can include a combination of wafer bonding and then grinding/polishing or chemical-mechanical polishing for thinning the silicon carbide substrate, followed by photo-electrochemical etching from the carbon-face of the silicon carbide substrate. By making use of its material-selective etching property, the photo-electrochemical etching used in the listed example planarizes the silicon carbide layer into a clean crystal interface, resulting in a uniform silicon carbide film thickness.

To facilitate the photo-electrochemical etching, an electrode can be attached to another doped layer of the silicon carbide layer located beneath the surface being etched or the doped layer being etched and a second electrode can be located in the etching fluid. Applying photo-electrochemical etching in this way offers a different process for producing silicon carbide on insulator films compared to currently used techniques. Furthermore, the process in the illustrative example can be used to produce sub-micron thick films of silicon carbide and group III nitrides in a manner that preserves doped layers (e.g. p-i-n junctions) and structures beneath the exposed silicon carbide surface.

The resulting restructure can take many different forms in the illustrative examples. For example, without limitation, the semiconductor structure can be selected from at least one of an optical waveguide, a slot waveguide, a ridge waveguide, a rib waveguide, a buried optical waveguide, a suspended waveguide, an optical resonator, or a photon emitting quantum memory using a point defect within the silicon carbide device layer. In other words, the semiconductor structure can include one or more of these devices and can include multiple devices of the same type.

The description of the different illustrative embodiments has been presented for purposes of illustration and description and is not intended to be exhaustive or limited to the embodiments in the form disclosed. The different illustrative examples describe components that perform actions or operations. In an illustrative embodiment, a component can be configured to perform the action or operation described. For example, the component can have a configuration or design for a structure that provides the component an ability to perform the action or operation that is described in the illustrative examples as being performed by the component. Further, to the extent that terms "includes", "including", "has", "contains", and variants thereof are used herein, such terms are intended to be inclusive in a manner similar to the term "comprises" as an open transition word without precluding any additional or other elements.

Further, the disclosure comprises embodiments according to the following clauses:
Clause 1. A method for forming a semiconductor structure, the method comprising:
   forming a set of group III nitride layers on a silicon carbide substrate, wherein the silicon carbide substrate includes a doped layer and wherein the doped layer has a doping level such that the doped layer is etched using a photo-electrochemical etching process while other portions of the silicon carbide substrate remain unetched;
   forming a first oxide layer on the set of group III nitride layers, wherein the set of group III nitride layers is located between the first oxide layer and the silicon carbide substrate;
   bonding the first oxide layer to a first oxide layer on a carrier substrate to form an oxide layer located between the carrier substrate and the set of group III nitride layers;
   grinding the silicon carbide substrate;
   stopping the grinding when a part of the doped layer in the silicon carbide substrate is reached;
   etching the silicon carbide substrate using the photo-electrochemical etching process such that the doped layer is removed and a silicon carbide device layer in the silicon carbide substrate remains when the part of the doped layer in the silicon carbide substrate is exposed; and
   forming the semiconductor structure using the silicon carbide device layer and the set of group III nitride layers.
Clause 2. The method of Clause 1, wherein bonding the first oxide layer to the first oxide layer on the carrier substrate to form the oxide layer located between the carrier substrate and the set of group III nitride layers is performed after etching the silicon carbide substrate.
Clause 3. The method of any preceding clause, wherein bonding the first oxide layer to the first oxide layer on the carrier substrate to form the oxide layer located between the carrier substrate and the set of group III nitride layers is performed after etching a group III nitride layer in the set of group III nitride layers.
Clause 4. The method of any preceding clause, wherein bonding the first oxide layer to the first oxide layer on the carrier substrate to form the oxide layer located between the carrier substrate and the set of group III nitride layers is performed prior to etching the silicon carbide substrate.
Clause 5. The method of any preceding clause, wherein bonding the first oxide layer to the first oxide layer on the carrier substrate to form the oxide layer located between the carrier substrate and the set of group III nitride layers comprises:
   contacting a first surface of the first oxide layer to a second surface of the first oxide layer, wherein intermolecular interactions occur between the first oxide layer and the first oxide layer; and
   annealing the first oxide layer and the first oxide layer while the first surface is in direct contact with the second surface to form the oxide layer located between the carrier substrate and the set of group III nitride layers.
Clause 6. The method of any preceding clause, wherein etching the silicon carbide substrate using the photo-electrochemical etching process such that the doped layer is removed and the silicon carbide device layer in the silicon carbide substrate remains when the part of the doped layer in the silicon carbide substrate is exposed comprises:
   etching one of a silicon-face and a carbon-face of the silicon carbide substrate using the photo-electrochemical etching process such that the doped layer is removed and the silicon carbide device layer in the silicon carbide substrate remains when the part of the doped layer in the silicon carbide substrate is exposed.
Clause 7. The method of any preceding clause, wherein the doped layer is a sacrificial layer enabling forming the silicon carbide device layer on a wafer with at least one of a desired uniformity in a thickness of the silicon carbide device layer or a desired level of optical performance.
Clause 8. The method of Clause 1, wherein the semiconductor structure is selected from at least one of an optical waveguide, a slot waveguide, a ridge waveguide, a rib waveguide, a buried optical waveguide, a suspended waveguide, an optical resonator, or a photon emitting quantum memory using a point defect within the silicon carbide device layer.
Clause 9. The method of any preceding clause, wherein the silicon carbide device layer and the set of group III nitride layers are thin-film layers.
Clause 10. The method of Clause 1, wherein the carrier substrate is one of a silicon carbide substrate, a silicon substrate, an aluminum oxide substrate, a gallium oxide substrate, a silica substrate, an aluminum nitride substrate, and a gallium nitride substrate.
Clause 11. The method of any preceding clause, wherein the set of group III nitride layers comprises at least one of gallium nitride (GaN), aluminum nitride (AlN), indium nitride (InN), and indium aluminum gallium nitride (InAlGaN).
Clause 12. A method for forming a semiconductor structure, the method comprising:
   bonding a first oxide layer located on a set of group III nitride layers formed on a silicon carbide substrate to a first oxide layer located on a carrier substrate to form an oxide layer located between the carrier substrate and the set of group III nitride layers, wherein the silicon carbide substrate has a doped layer;
   etching the silicon carbide substrate having the doped layer using a photo-electrochemical etching process, wherein a doping level of the doped layer is such that the doped layer is removed and a silicon carbide device layer in the silicon carbide substrate remains unetched; and
   forming the semiconductor structure using the silicon carbide device layer and the set of group III nitride layers.
Clause 13. The method of Clause 12 further comprising:
   grinding the silicon carbide substrate prior to etching the silicon carbide substrate; and
   stopping the grinding of the silicon carbide substrate when a part of the doped layer in the silicon carbide substrate is reached prior to etching the silicon carbide substrate.
Clause 14. The method of any of clauses 12-13 further comprising:
   forming the set of group III nitride layers on the silicon carbide substrate; and
   forming the first oxide layer on the set of group III nitride layers, wherein the set of group III nitride layers is located between the first oxide layer and the silicon carbide substrate.
Clause 15. The method of any of clauses 12-14, wherein bonding the first oxide layer located on the set of group III nitride layers formed on the silicon carbide substrate to the first oxide layer located on the carrier substrate to form the oxide layer located between the carrier substrate and the set of group III nitride layers is performed after etching the silicon carbide substrate.
Clause 16. The method of any of clauses 12-15, wherein bonding the first oxide layer to the first oxide layer on the carrier substrate to form the oxide layer located between the carrier substrate and the set of group III nitride layers is performed after etching a group III nitride layer in the set of group III nitride layers.
Clause 17. The method of any of clauses 12-16, wherein bonding the first oxide layer located on the set of group III nitride layers formed on the silicon carbide substrate to the first oxide layer located on the carrier substrate to form the oxide layer located between the carrier substrate and the set of group III nitride layers is performed prior to etching the silicon carbide substrate.
Clause 18. The method of any of clauses 12-17, wherein bonding the first oxide layer located on the set of group III nitride layers formed on the silicon carbide substrate to the first oxide layer located on the carrier substrate to form the oxide layer located between the carrier substrate and the set of group III nitride layers comprises:
   contacting a first surface of the first oxide layer to a second surface of the first oxide layer, wherein intermolecular interactions occur between the first oxide layer and the first oxide layer; and
   annealing the first oxide layer and the first oxide layer while the first surface is in direct contact with the second surface to form the oxide layer located between the carrier substrate and the set of group III nitride layers.
Clause 19. The method of any of clauses 12-18, wherein the doped layer is a sacrificial layer enabling forming the silicon carbide device layer on a wafer with at least one of a desired uniformity in a thickness of the silicon carbide device layer or a desired level of optical performance.
Clause 20. The method of any of clauses 12-19, wherein the semiconductor structure is selected from at least one of an optical waveguide, a slot waveguide, a ridge waveguide, a rib waveguide, a buried optical waveguide, a suspended waveguide, an optical resonator, or a photon emitting quantum memory using a point defect within the silicon carbide device layer.
Clause 21. The method of any of clauses 12-20, wherein the silicon carbide device layer and the set of group III nitride layers are thin-film layers.
Clause 22. The method of any of clauses 12-21, wherein the carrier substrate is one of a silicon carbide substrate, a silicon substrate, an aluminum oxide substrate, a gallium oxide substrate, a silica substrate, an aluminum nitride substrate, and a gallium nitride substrate.
Clause 23. The method of any of clauses 12-22, wherein the set of group III nitride layers comprises at least one of gallium nitride (GaN), aluminum nitride (AlN), indium nitride (InN), and indium aluminum gallium nitride (InAlGaN).
Clause 24. A method for forming a semiconductor structure, the method comprising:
   bonding a first oxide layer located on a silicon carbide substrate to a first oxide layer located on a carrier substrate to form an oxide layer located between the carrier substrate and a silicon carbide substrate, wherein the silicon carbide substrate has a doped layer;
   etching the silicon carbide substrate having the doped layer using a photo-electrochemical etching process, wherein a doping level of the doped layer is such that the doped layer is removed and a silicon carbide device layer in the silicon carbide substrate remains unetched; and
   forming the semiconductor structure using the silicon carbide device layer.
Clause 25. The method of Clause 24, wherein etching the silicon carbide substrate having the doped layer using the photo-electrochemical etching process comprises:
   etching a carbon-face of the silicon carbide substrate having the doped layer using a photo-electrochemical etching process, wherein the doping level of the doped layer is such that the doped layer is removed and the silicon carbide device layer in the silicon carbide substrate remains unetched.
Clause 26. The method of any of clauses 24-25, wherein the first oxide layer is in direct contact with the silicon carbide substrate.
Clause 27. The method of any of clauses 24-26, wherein a set of group III nitride layers are located between the first oxide layer and the silicon carbide substrate.
Clause 28. A product management system comprising:
   fabrication equipment; and
   a control system, wherein the control system controls the fabrication equipment to:
      bond a first oxide layer located on a set of group III nitride layers formed on a silicon carbide substrate to a first oxide layer located on a carrier substrate to form an oxide layer located between the carrier substrate and the set of group III nitride layers, wherein the silicon carbide substrate has a doped layer;
      etch the silicon carbide substrate having the doped layer using a photo-electrochemical etching process, wherein a doping level of the doped layer is such that the doped layer is removed and a silicon carbide device layer in the silicon carbide substrate remains unetched; and
      form a semiconductor structure using the silicon carbide device layer and the set of group III nitride layers.
Clause 29. The product management system of Clause 28, wherein the control system controls the fabrication equipment to further comprise:
   grinding the silicon carbide substrate prior to etching the silicon carbide substrate; and
   stop grinding of the silicon carbide substrate when a part of the doped layer in the silicon carbide substrate is reached prior to etching the silicon carbide substrate.
Clause 30. The product management system of any of clauses 28-29, wherein the control system controls the fabrication equipment to:
   form the set of group III nitride layers on the silicon carbide substrate; and
   form the first oxide layer on set of group III nitride layers, wherein the set of group III nitride layers is located between the first oxide layer and the silicon carbide substrate.
Clause 31. The product management system of any of clauses 28-30, wherein the semiconductor structure is selected from at least one of an optical waveguide, a slot waveguide, a ridge waveguide, a rib waveguide, a buried optical waveguide, a suspended waveguide, an optical resonator, or a photon emitting quantum memory using a point defect within the silicon carbide device layer.
Clause 32. The product management system of any of clauses 28-31, wherein the silicon carbide device layer and the set of group III nitride layers are thin-film layers.
Clause 33. The product management system of any of clauses 28-32, wherein the carrier substrate is one of a silicon carbide substrate, a silicon substrate, an aluminum oxide substrate, a gallium oxide substrate, a silica substrate, an aluminum nitride substrate, and a gallium nitride substrate.
Clause 34. The product management system of any of clauses 28-33, wherein the set of group III nitride layers comprises at least one of gallium nitride (GaN), aluminum nitride (AlN), indium nitride (InN), and indium aluminum gallium nitride (InAlGaN) .
Clause 35. A semiconductor structure comprising:
   a substrate;
   an oxide layer on the substrate;
   a set of group III nitride layers on the oxide layer; and
   a set of silicon carbide layers on the set of group III nitride layers.
Clause 36. The semiconductor structure of Clause 35, wherein the set of group III nitride layers on the oxide layer is a set of group III nitride regions.
Clause 37. The semiconductor structure of Clause 36, wherein the set of group III nitride regions is buried in a cavity in the oxide layer.
Clause 38. The semiconductor structure of Clause 37, further comprising:
   a cladding on the set of silicon carbide layers, wherein the cladding has a lower refractive index than a refractive index for the set of silicon carbide layers.
Clause 39. The semiconductor structure of any of clauses 35-38, wherein the set of silicon carbide layers is a set of silicon carbide regions.
Clause 40. The semiconductor structure of Clause 39, wherein the set of group III nitride layers on the oxide layer is a set of group III nitride regions.
Clause 41. The semiconductor structure of Clause 40 further comprising:
   a defect in a silicon carbide material in the set of silicon carbide layers.
Clause 42. The semiconductor structure of Clause 41, wherein the defect is one of a divacancy, silicon monovacancy, other vacancy complex, transition metal ion, and a rare earth ion.
Clause 43. The semiconductor structure of Clause 39, wherein the set of silicon carbide regions forms a waveguide.
Clause 44. The semiconductor structure of Clause 43 further comprising:
   a cladding on the set of silicon carbide regions, wherein the cladding has a lower refractive index than a refractive index for the set of silicon carbide regions.
Clause 45. The semiconductor structure of Clause 44, wherein the cladding is comprised of a material selected from at least one of air, vacuum, resist, polymer, silicon dioxide, or silicon nitride.
Clause 46. The semiconductor structure of Clause 45, wherein the set of silicon carbide layers comprises a silicon carbide layer and a silicon carbide region extending from the silicon carbide layer.
Clause 47. The semiconductor structure of Clause 46 further comprising:
   a cladding on the silicon carbide layer and the silicon carbide region, wherein the cladding has a lower refractive index than a refractive index for the silicon carbide layer and the silicon carbide region.
Clause 48. The semiconductor structure of Clause 45, wherein the set of group III nitride layers is in direct contact with the oxide layer.
Clause 49. The semiconductor structure of Clause 45, wherein set of silicon carbide layers is in direct contact with the set of group III nitride layers.
Clause 50. The semiconductor structure of Clause 45, wherein the substrate is one of a silicon carbide substrate, a silicon substrate, an aluminum oxide substrate, a gallium oxide substrate, a silica substrate, an aluminum nitride substrate, and a gallium nitride substrate.
Clause 51. The semiconductor structure of Clause 45, wherein the set of group III nitride layers comprises at least one of gallium nitride (GaN), aluminum nitride (AlN), indium nitride (InN), and indium aluminum gallium nitride (InAlGaN).
Clause 52. The semiconductor structure of Clause 45, wherein the set of silicon carbide layers and the set of group III nitride layers are thin-film layers.
Clause 53. The semiconductor structure of Clause 45, wherein the semiconductor structure is selected from at least one of an optical waveguide, a slot waveguide, a ridge waveguide, a rib waveguide, a buried optical waveguide, a suspended waveguide, or an optical resonator.
Clause 54. A semiconductor structure comprising:
   a substrate;
   an oxide layer on the substrate; and
   a set of silicon carbide layers on the substrate.
Clause 55. The semiconductor structure of Clause 54, wherein the set of silicon carbide layers on the substrate is in direct contact with the oxide layer.
Clause 56. The semiconductor structure of any of clauses 54-55 further comprising:
   a set of group III nitride layers on the oxide layer such that the set of group III nitride layers is located between the oxide layer and the set of silicon carbide layers.
Clause 57. The semiconductor structure of any of clauses 54-56, wherein the set of silicon carbide layers is a set of silicon carbide regions.
Clause 58. The semiconductor structure of any of clauses 54-57, wherein the set of silicon carbide layers comprises a silicon carbide layer and a silicon carbide region extending from the silicon carbide layer.
Clause 59. The semiconductor structure of Clause 58 further comprising:
   a cladding on the silicon carbide layer and the silicon carbide region, wherein the cladding has a lower refractive index than a refractive index for the silicon carbide layer and the silicon carbide region.
Clause 60. The semiconductor structure of Clause 59, wherein the cladding is comprised of a material selected from at least one of air, vacuum, resist, polymer, silicon dioxide, or silicon nitride.
Clause 61. The semiconductor structure of any of clauses 54-60, wherein the set of silicon carbide layers is a set of thin-film layers.
Clause 62. The semiconductor structure of claim 54, wherein the substrate is one of a silicon carbide substrate, a silicon substrate, an aluminum oxide substrate, a gallium oxide substrate, a silica substrate, an aluminum nitride substrate, and a gallium nitride substrate.

Many modifications and variations will be apparent to those of ordinary skill in the art. Further, different illustrative embodiments may provide different features as compared to other desirable embodiments. The embodiment or embodiments selected are chosen and described in order to best explain the principles of the embodiments, the practical application, and to enable others of ordinary skill in the art to understand the disclosure for various embodiments with various modifications as are suited to the particular use contemplated.

## Claims

1. A method for forming a semiconductor structure, the method comprising:
bonding (2800) a first oxide layer (402, 912) located on a set of group III nitride layers (200, 908, 910, 1308, 1310, 1606, 1806, 2006, 2106, 2210, 2212, 2310, 2312) formed on a silicon carbide substrate (100, 1003) to a first oxide layer (504, 1002) located on a carrier substrate (500, 1000, 1314, 1602, 1802, 2002, 2102, 2202, 2302, 2402) to form an oxide layer (600, 1100, 1312, 1604, 1804, 2004, 2104, 2204, 2304) located between the carrier substrate (500, 1000, 1314, 1602, 1802, 2002, 2102, 2202, 2302, 2402) and the set of group III nitride layers (200, 908, 910, 1308, 1310, 1606, 1806, 2006, 2106, 2210, 2212, 2310, 2312), wherein the silicon carbide substrate (100, 1003) has a doped layer (106, 904, 1302);
etching (2082) the silicon carbide substrate (100, 1003) having the doped layer (106, 904, 1302) using a photo-electrochemical etching process, wherein a doping level of the doped layer (106, 904, 1302) is such that the doped layer (106, 904, 1302) is removed and a silicon carbide device layer (100, 906) in the silicon carbide substrate (100, 1003) remains unetched; and
forming (2804) the semiconductor structure using the silicon carbide device layer (100, 906) and the set of group III nitride layers (200, 908, 910, 1308, 1310, 1606, 1806, 2006, 2106, 2210, 2212, 2310, 2312).

2. The method of claim 1 further comprising:
grinding (2606) the silicon carbide substrate (100, 1003) prior to etching the silicon carbide substrate (100, 1003).

3. The method of claim 2 further comprising stopping (2608) the grinding of the silicon carbide substrate (100, 1003) when a part of the doped layer (106, 904, 1302) in the silicon carbide substrate (100, 1003) is reached prior to etching the silicon carbide substrate (100, 1003).

4. The method of any of claims 1-3, further comprising forming (2600) the set of group III nitride layers (200, 908, 910, 1308, 1310, 1606, 1806, 2006, 2106, 2210, 2212, 2310, 2312) on the silicon carbide substrate (100, 1003).

5. The method of any of claims 1-4, further comprising forming (2602) the first oxide layer (402, 912) on the set of group III nitride layers (200, 908, 910, 1308, 1310, 1606, 1806, 2006, 2106, 2210, 2212, 2310, 2312), wherein the set of group III nitride layers (200, 908, 910, 1308, 1310, 1606, 1806, 2006, 2106, 2210, 2212, 2310, 2312) is located between the first oxide layer (402, 912) and the silicon carbide substrate (100, 1003).

6. The method of any of claims 1-5, wherein bonding the first oxide layer (402, 912) located on the set of group III nitride layers (200, 908, 910, 1308, 1310, 1606, 1806, 2006, 2106, 2210, 2212, 2310, 2312) formed on the silicon carbide substrate (100, 1003) to the first oxide layer (504, 1002) located on the carrier substrate (500, 1000, 1314, 1602, 1802, 2002, 2102, 2202, 2302, 2402) to form the oxide layer (600, 1100, 1312, 1604, 1804, 2004, 2104, 2204, 2304) located between the carrier substrate (500, 1000, 1314, 1602, 1802, 2002, 2102, 2202, 2302, 2402) and the set of group III nitride layers (200, 908, 910, 1308, 1310, 1606, 1806, 2006, 2106, 2210, 2212, 2310, 2312) is performed after etching the silicon carbide substrate (100, 1003).

7. The method of any of claims 1-6, wherein bonding the first oxide layer (402, 912) to the first oxide layer (504, 1002) on the carrier substrate (500, 1000, 1314, 1602, 1802, 2002, 2102, 2202, 2302, 2402) to form the oxide layer (600, 1100, 1312, 1604, 1804, 2004, 2104, 2204, 2304) located between the carrier substrate (500, 1000, 1314, 1602, 1802, 2002, 2102, 2202, 2302, 2402) and the set of group III nitride layers (200, 908, 910, 1308, 1310, 1606, 1806, 2006, 2106, 2210, 2212, 2310, 2312) is performed after etching a group III nitride layer in the set of group III nitride layers (200, 908, 910, 1308, 1310, 1606, 1806, 2006, 2106, 2210, 2212, 2310, 2312).

8. The method of any of claims 1-7, wherein bonding the first oxide layer (402, 912) located on the set of group III nitride layers (200, 908, 910, 1308, 1310, 1606, 1806, 2006, 2106, 2210, 2212, 2310, 2312) formed on the silicon carbide substrate (100, 1003) to the first oxide layer (504, 1002) located on the carrier substrate (500, 1000, 1314, 1602, 1802, 2002, 2102, 2202, 2302, 2402) to form the oxide layer (600, 1100, 1312, 1604, 1804, 2004, 2104, 2204, 2304) located between the carrier substrate (500, 1000, 1314, 1602, 1802, 2002, 2102, 2202, 2302, 2402) and the set of group III nitride layers (200, 908, 910, 1308, 1310, 1606, 1806, 2006, 2106, 2210, 2212, 2310, 2312) is performed prior to etching the silicon carbide substrate (100, 1003).

9. The method of any of claims 1-8, wherein bonding the first oxide layer (402, 912) located on the set of group III nitride layers (200, 908, 910, 1308, 1310, 1606, 1806, 2006, 2106, 2210, 2212, 2310, 2312) formed on the silicon carbide substrate (100, 1003) to the first oxide layer (504, 1002) located on the carrier substrate (500, 1000, 1314, 1602, 1802, 2002, 2102, 2202, 2302, 2402) to form the oxide layer (600, 1100, 1312, 1604, 1804, 2004, 2104, 2204, 2304) located between the carrier substrate (500, 1000, 1314, 1602, 1802, 2002, 2102, 2202, 2302, 2402) and the set of group III nitride layers (200, 908, 910, 1308, 1310, 1606, 1806, 2006, 2106, 2210, 2212, 2310, 2312) comprises:
contacting (2700) a first surface of the first oxide layer (402, 912) to a second surface of the first oxide layer (504, 1002), wherein intermolecular interactions occur between the first oxide layer (402, 912) and the first oxide layer (504, 1002); and
annealing (2702) the first oxide layer (402, 912) and the first oxide layer (504, 1002) while the first surface is in direct contact with the second surface to form the oxide layer (600, 1100, 1312, 1604, 1804, 2004, 2104, 2204, 2304) located between the carrier substrate (500, 1000, 1314, 1602, 1802, 2002, 2102, 2202, 2302, 2402) and the set of group III nitride layers (200, 908, 910, 1308, 1310, 1606, 1806, 2006, 2106, 2210, 2212, 2310, 2312).

10. The method of any of claims 1-9, wherein the doped layer (106, 904, 1302) is a sacrificial layer enabling forming the silicon carbide device layer (100, 906) on a wafer with at least one of a desired uniformity in a thickness of the silicon carbide device layer (100, 906) or a desired level of optical performance.

11. The method of any of claims 1-10, wherein the semiconductor structure is selected from at least one of an optical waveguide, a slot waveguide, a ridge waveguide, a rib waveguide, a buried optical waveguide, a suspended waveguide, an optical resonator, or a photon emitting quantum memory using a point defect within the silicon carbide device layer (100, 906).

12. The method of any of claims 1-11, wherein the silicon carbide device layer (100, 906) and the set of group III nitride layers (200, 908, 910, 1308, 1310, 1606, 1806, 2006, 2106, 2210, 2212, 2310, 2312) are thin-film layers.

13. The method of any of claims 1-12, wherein the carrier substrate (500, 1000, 1314, 1602, 1802, 2002, 2102, 2202, 2302, 2402) is one of a silicon carbide substrate (100, 1003), a silicon substrate, an aluminum oxide substrate, a gallium oxide substrate, a silica substrate, an aluminum nitride substrate, and a gallium nitride substrate.

14. The method of any of claims 1-13, wherein the set of group III nitride layers (200, 908, 910, 1308, 1310, 1606, 1806, 2006, 2106, 2210, 2212, 2310, 2312) comprises at least one of gallium nitride (GaN), aluminum nitride (AlN), indium nitride (InN), and indium aluminum gallium nitride (InAlGaN).
